# EUROPEAN PATENT APPLICATION

(11) **EP 4 844 488 A1**
(43) Date of publication of application: **25.11.2026**
(21) Application number: 25741794.9
(22) Date of filing: 10.01.2025
(51) Int. Cl.: G03F 7/11, C08G 77/04, C08L 83/06, G03F 7/20

(54) **COMPOSITION FOR FORMING SILICON-CONTAINING UNDERLAYER FILM**

(30) Priority: 18.01.2024 JP 2024005977
(71) Applicant: Nissan Chemical Corporation, Tokyo 103-6119 (JP)
(72) Inventor: SHIBAYAMA, Wataru, Toyama-shi, Toyama 939-2792 (JP); FURUKAWA, Yuki, Toyama-shi, Toyama 939-2792 (JP); SAIJO, Taiki, Toyama-shi, Toyama 939-2792 (JP)
(74) Representative: Hoffmann Eitle
(86) International application number: PCT/JP2025/000597
(87) International publication number: WO 2025/154662

(57) **Abstract**

A composition for forming a silicon-containing underlayer film on which a surface modification layer having a film thickness of 5 nm or less is formed, the composition including: component [A]: a polysiloxane including 30 mol% or more of Q units relative to all units; and component [B]: water, the composition not including: component [C]: a curing catalyst.

## Description

### Technical Field

The present invention relates to a silicon-containing underlayer film-forming composition.

### Background Art

Conventionally, microfabrication by lithography using a photoresist has been performed in the production of a semiconductor device. The microfabrication is a processing method including: forming a photoresist thin film on a semiconductor substrate such as a silicon wafer; irradiating the thin film with active rays such as ultraviolet rays through a mask pattern having a semiconductor device pattern drawn thereon; developing the irradiated thin film; and etching the substrate with the resultant photoresist pattern serving as a protective film to form, on the surface of the substrate, fine irregularities corresponding to the pattern.

In recent years, as a result of an increase in the degree of integration of semiconductor devices, active rays having a shorter wavelength have tended to be used, with a shift from KrF excimer laser (248 nm) to ArF excimer laser (193 nm). The use of such active rays having a shorter wavelength causes a serious problem in terms of reflection of active rays from a semiconductor substrate. In order to avoid such a problem, there has been widely used a method of providing a resist underlayer film called anti-reflective coating (Bottom Anti-Reflective Coating, BARC) between a photoresist and a to-be-processed substrate.

As an advanced microfabrication technology, mass production of devices at the 10 nm node using double patterning with ArF immersion lithography has been carried out. As a next generation technology, preparations are underway for mass production of devices at the 7 nm node using double patterning with ArF immersion lithography. Extreme ultraviolet (EUV) lithography at a wavelength of 13.5 nm is being considered as a candidate for a mass production technology for the 5 nm node, which is a next-next generation technology.

In the advanced microfabrication, it is difficult to perform miniaturization only with a resist film, and the miniaturization process is not established unless a hard mask formed below the resist film is used. Under such circumstances, there is a multilayer resist method as one method of using a hard mask as a resist underlayer film. This method is a method in which an underlayer film having different etching selectivity from a resist film, for example, a silicon-containing resist underlayer film is interposed between the resist film and an to-be-processed substrate to obtain a pattern of the resist film, then the pattern is transferred to the silicon-containing resist underlayer film by dry etching using the resist pattern as an etching mask, and the pattern is transferred to the to-be-processed substrate or a film to be a core for a spacer process by dry etching using the silicon-containing resist underlayer film as an etching mask.

As a composition for forming a silicon-containing resist underlayer film applicable to the multilayer resist method, a resist underlayer film-forming composition including a silicon-containing compound obtained by hydrolyzing or condensing a specific silicon compound or both has been proposed (refer to, for example, Patent Literature 1).

### Citation List

### Patent Literature

Patent Literature 1: JP 2014-157242 A

### Summary of Invention

### Technical Problem

As the resist pattern becomes finer in the advanced microfabrication, thinning of the silicon-containing resist underlayer film is required. While the silicon-containing resist underlayer film is required to have adhesion to a resist film, etching resistance, and the like, it is difficult for a thin silicon-containing resist underlayer film to satisfy all these requirements.

The present invention has been made in view of such circumstances, and an object thereof is to provide a technique capable of coping with miniaturization of a resist pattern by a combination of a surface modification layer and a silicon-containing underlayer film in place of a single-layer silicon-containing resist underlayer film.

An object of the present invention is to provide a silicon-containing underlayer film-forming composition for forming a silicon-containing underlayer film in a technology capable of coping with miniaturization of a resist pattern by a combination of a surface modification layer and a silicon-containing underlayer film.

An object of the present invention is to provide a method for producing a semiconductor element and a method for forming a pattern, both methods capable of coping with miniaturization of a resist pattern by a combination of a surface modification layer and a silicon-containing underlayer film.

### Solution to Problem

As a result of intensive studies to solve the above-mentioned problems, the present inventors have found that the above-mentioned problems can be solved, and completed the present invention having the following gist.

That is, the present invention includes the following items.
[1] A composition for forming a silicon-containing underlayer film on which a surface modification layer having a film thickness of 5 nm or less is formed, the composition including:
   component [A]: a polysiloxane including 30 mol% or more of Q units relative to all units; and
   component [B]: water, the composition not including:
      component [C]: a curing catalyst
[2] A composition for forming a silicon-containing underlayer film on which a surface modification layer having a film thickness of 5 nm or less is formed, wherein
   the surface modification layer is formed on the silicon-containing underlayer film subjected to at least one of a dry etching treatment, a baking treatment at 250°C or more, and a UV irradiation treatment, and
   the composition includes the component [A]: polysiloxane including 30 mol% or more of Q units relative to all units.
[3] The silicon-containing underlayer film-forming composition according to [2], wherein
   atmospheric gas in the dry etching treatment includes at least one of an oxygen gas, a hydrogen gas, a nitrogen gas, and a rare gas, and
   a wavelength in the UV irradiation treatment is 170 nm to 370 nm, and atmosphere is either an atmosphere including oxygen or a nitrogen atmosphere.
[4] The silicon-containing underlayer film-forming composition according to [1] or [2], wherein
   the polysiloxane as the component [A] is a hydrolysis condensate of a hydrolyzable silane (Si-1), and
   the hydrolyzable silane (Si-1) includes 30 mol% or more of a hydrolyzable silane represented by the following formula (A):
      [Chem. 1]

      **SiR4** **(A)**
   wherein R is a group or atom bonded to a silicon atom, and each independently represents an alkoxy group, an aralkyloxy group, an acyloxy group, or a halogen atom.
[5] The silicon-containing underlayer film-forming composition according to [4], wherein the hydrolyzable silane (Si-1) further includes a hydrolyzable silane represented by the following formula (B):
   [Chem. 2]

   **R¹¹**ₐSi(**R**¹²)₄₋ₐ **(B)**

   wherein R¹¹ represents a group bonded to a silicon atom, and each independently represents an organic group having a number of carbon atoms of 1 to 45,
   R¹² is a group or atom bonded to a silicon atom, and each independently represents an alkoxy group, an aralkyloxy group, an acyloxy group, or a halogen atom, and
   a represents an integer of 1 to 3.
[6] The silicon-containing underlayer film-forming composition according to any one of [1] to [5], wherein the surface modification layer is formed using a surface modification layer-forming composition containing a polysiloxane and a solvent.
[7] The silicon-containing underlayer film-forming composition according to [6], wherein
   the polysiloxane contained in the surface modification layer-forming composition is a hydrolysis condensate of a hydrolyzable silane (Si-2), and
   the hydrolyzable silane (Si-2) includes a hydrolyzable silane represented by the following formula (S1):
      [Chem. 3]

      **R²¹ₐSi(R²²)₄₋ₐ** **(S1)**
   wherein R²¹ represents a group bonded to a silicon atom, and each independently represents an organic group having a number of carbon atoms of 1 to 45,
   R²² is a group or atom bonded to a silicon atom, and each independently represents an alkoxy group, an aralkyloxy group, an acyloxy group, or a halogen atom, and
   a represents an integer of 1 to 3.
[8] The silicon-containing underlayer film-forming composition according to any one of [1] to [7], wherein the component [A] includes a modified polysiloxane in which at least some of silanol groups are alcohol-modified or acetal-protected.
[9] The silicon-containing underlayer film-forming composition according to any one of [1] to [8], including an alcohol-based solvent.
[10] The silicon-containing underlayer film-forming composition according to [9], wherein the alcohol-based solvent includes propylene glycol monoalkyl ether.
[11] The silicon-containing underlayer film-forming composition according to any one of [1] to [10], including nitric acid.
[12] The silicon-containing underlayer film-forming composition according to any one of [1] to [11], wherein the composition is used for EUV lithography.
[13] A silicon-containing underlayer film which is a cured product of the silicon-containing underlayer film-forming composition according to any one of [1] to [12].
[14] A semiconductor processing substrate including: a semiconductor substrate; and the silicon-containing underlayer film according to [13].
[15] A method for producing a semiconductor element, the method including:
   a step of forming an organic underlayer film on a substrate;
   a step of forming a silicon-containing underlayer film using the silicon-containing underlayer film-forming composition according to any one of [1] to [12] on the organic underlayer film;
   a step of forming a surface modification layer on the silicon-containing underlayer film; and
   a step of forming a resist film on the surface modification layer.
[16] The method for producing a semiconductor element according to [15], wherein the step of forming the silicon-containing underlayer film includes at least one of dry etching treatment, baking treatment at 250°C or more, and UV irradiation treatment.
[17] The method for producing a semiconductor element according to [16], wherein
   atmospheric gas in the dry etching treatment includes at least one of an oxygen gas, a hydrogen gas, a nitrogen gas, and a rare gas, and
   a wavelength in the UV irradiation treatment is 170 nm to 370 nm, and atmosphere is either an atmosphere including oxygen or a nitrogen atmosphere.
[18] A method for forming a pattern, including:
   a step of forming an organic underlayer film on a semiconductor substrate;
   a step of applying the silicon-containing underlayer film-forming composition according to any one of [1] to [12] on the organic underlayer film and baking the composition to form a silicon-containing underlayer film;
   a step of forming a surface modification layer on the silicon-containing underlayer film;
   a step of forming a resist film on the surface modification layer;
   a step of exposing and developing the resist film to obtain a resist pattern;
   a step of etching the surface modification layer and the silicon-containing underlayer film using the resist pattern as a mask; and
   a step of etching the organic underlayer film using the patterned surface modification layer and silicon-containing underlayer film as a mask.
[19] The method for forming a pattern according to [18], wherein the step of forming the silicon-containing underlayer film includes at least one of dry etching treatment, baking treatment at 250°C or more, and UV irradiation treatment.
[20] The method for forming a pattern according to [19], wherein
   atmospheric gas in the dry etching treatment includes at least one of an oxygen gas, a hydrogen gas, a nitrogen gas, and a rare gas, and
   the wavelength in the UV irradiation treatment is 170 nm to 370 nm, and atmosphere is either an atmosphere including oxygen or a nitrogen atmosphere.
[21] The method for forming a pattern according to [18], further including:
   a step of removing the resist underlayer film by a wet method using a chemical liquid after the step of etching the organic underlayer film.

### Advantageous Effects of Invention

The present invention can provide a technology capable of coping with miniaturization of a resist pattern by a combination of a surface modification layer and a silicon-containing underlayer film in place of a single-layer silicon-containing resist underlayer film.

The present invention can provide a silicon-containing underlayer film-forming composition for forming a silicon-containing underlayer film in a technology capable of coping with miniaturization of a resist pattern by a combination of a surface modification layer and a silicon-containing underlayer film.

The present invention can provide a method for producing a semiconductor element and a method for forming a pattern, both methods capable of coping with miniaturization of a resist pattern by a combination of a surface modification layer and a silicon-containing underlayer film.

### Description of Embodiments

### (Silicon-containing underlayer film-forming composition)

The silicon-containing underlayer film-forming composition of the present invention is a composition for forming a silicon-containing underlayer film on which a surface modification layer having a film thickness of 5 nm or less is formed.

It is not typically easy to form a thin layer on the silicon-containing underlayer film, but using the silicon-containing underlayer film-forming composition of the present invention makes it possible to form a surface modification layer having a film thickness of 5 nm or less in a favorable film state.

Then, the functions conventionally performed by the single-layer silicon-containing resist underlayer film are separated into a surface modification layer and a silicon-containing underlayer film, and the surface modification layer is provided with a function of improving resist pattern formation (for example, improvement in adhesion), and the silicon-containing underlayer film is provided with a function of etching resistance, thereby making it possible to cope with miniaturization of the resist pattern.

### <First Embodiment>

The first embodiment of the silicon-containing underlayer film-forming composition of the present invention contains the component [A] and the component [B] but does not contain the component [C].

The component [A] is a polysiloxane including 30 mol% or more of Q units relative to all units.

The component [B] is water.

The component [C] is a curing catalyst.

### <Second Embodiment>

The second embodiment of the silicon-containing underlayer film-forming composition of the present invention contains the component [A].

The component [A] is a polysiloxane including 30 mol% or more of Q units relative to all units.

In the second embodiment, the surface modification layer is formed on the silicon-containing underlayer film subjected to at least one of a dry etching treatment, a baking treatment at 250°C or more, and a UV irradiation treatment. Details of these treatments will be described together when the details of the method for producing the semiconductor element of the present invention are described.

In the second embodiment, for example, the silicon-containing underlayer film-forming composition may contain a curing catalyst. The present inventors believe that when the silicon-containing underlayer film-forming composition contains a curing catalyst, the number of Si-OH groups derived from polysiloxane tends to decrease in the silicon-containing underlayer film obtained from the silicon-containing underlayer film-forming composition. In that case, when an attempt is made to form the surface modification layer on the silicon-containing underlayer film, the film formability of the surface modification layer is deteriorated. Therefore, in the second embodiment, at least one of a dry etching treatment, a baking treatment at 250°C or more, and a UV irradiation treatment is performed before the formation of the surface modification layer. Performing these treatments causes the film formability of the surface modification layer on the silicon-containing underlayer film to be improved.

### <Component [A]>

The polysiloxane as the component [A] includes 30 mol% or more of the Q units, preferably includes 45 mol% or more, and more preferably includes 60 mol% or more relative to all units.

The upper limit of the ratio of the Q unit to all units in the polysiloxane is not particularly limited, and the ratio of the Q unit may be, for example, 100 mol% or less, 90 mol% or less, or 85 mol% or less.

The "all units" refers to the sum of an M unit, a D unit, a T unit, and a Q unit, which constitutes the polysiloxane. The polysiloxane does not need to have all of the M unit, the D unit, the T unit, and the Q unit.

The M unit means a siloxy unit represented by (R)₃SiO_{1/2}. Herein, Rs each independently represent a hydrogen atom or an organic group. The number after (R) (herein, 3) means that three hydrogen atoms or organic groups are bonded to the silicon atom. That is, the M unit has one silicon atom, three hydrogen atoms or organic groups, and one oxygen atom O*. More specifically, the M unit has three hydrogen atoms or organic groups bonded to one silicon atom and an oxygen atom O* bonded to one silicon atom.

The D unit means a siloxy unit represented by (R)₂SiO_{2/2} (Rs each independently represent a hydrogen atom or an organic group). That is, the D unit is a unit having one silicon atom and having two hydrogen atoms or organic groups bonded to the silicon atom and two oxygen atoms O* bonded to another silicon atom.

The T unit means a siloxy unit represented by RSiO_{3/2} (R represents a hydrogen atom or an organic group). That is, the T unit is a unit having one silicon atom and having one hydrogen atom or organic group bonded to the silicon atom and three oxygen atoms O* bonded to another silicon atom.

The Q unit means a siloxy unit represented by SiO₂. That is, the Q unit is a unit having one silicon atom and four oxygen atoms O* bonded to another silicon atom.

The polysiloxane as the component [A] preferably includes 5 mol% or more of T units, more preferably 10 mol% or more, and particularly preferably 20 mol% or more relative to all units.

The upper limit of the ratio of the T unit to all units in the polysiloxane is not particularly limited, and the ratio of the T unit may be, for example, 70 mol% or less, 55 mol% or less, or 40 mol% or less.

The polysiloxane as the component [A] preferably includes the total of the Q unit and the T unit in an amount of 70 mol% to 100 mol%, more preferably 80 mol% to 100 mol%, and particularly preferably 90 mol% to 100 mol% relative to all units.

The polysiloxane may include a modified polysiloxane in which some of silanol groups are modified, for example, a polysiloxane modified product in which some of silanol groups are alcohol-modified or acetal-protected.

Further, the polysiloxane may contain, as an example, a hydrolysis condensate of a hydrolyzable silane, and may contain a modified polysiloxane in which at least some of silanol groups of the hydrolysis condensate are alcohol-modified or acetal-protected. The hydrolyzable silane related to the hydrolysis condensate may include one type or two or more types of hydrolyzable silanes.

The polysiloxane to be used may be a commercially available polysiloxane.

In the present invention, the "hydrolysis condensate", i.e. product of hydrolysis condensation, of the hydrolyzable silane includes not only a polyorganosiloxane polymer which is a condensate prepared through complete condensation, but also a polyorganosiloxane polymer which is a partial hydrolysis condensate prepared through incomplete condensation. Such a partial hydrolysis condensate is a polymer prepared through hydrolysis and condensation of a hydrolyzable silane compound, as in the case of a condensate prepared through complete condensation. However, the partial hydrolysis condensate contains remaining Si-OH groups, due to partial or incomplete hydrolysis and condensation of the silane compound. In addition, the surface modifier may contain an uncondensed hydrolysate (complete hydrolysate or partial hydrolysate) or a remaining monomer (hydrolyzable silane), in addition to the hydrolysis condensate.

In the present specification, the "hydrolyzable silane" may be simply referred to as "silane compound".

In addition, in the present specification, the "polysiloxane" may be referred to as "hydrolysis condensate".

The polysiloxane is suitably a hydrolysis condensate of a hydrolyzable silane (Si-1).

The hydrolyzable silane (Si-1) includes 30 mol% or more of a hydrolyzable silane represented by the following formula (A).
[Chem. 4]

**SiR4** **(A)**

In the formula (1), R represents a group or atom bonded to a silicon atom, and each independently represents an alkoxy group, an aralkyloxy group, an acyloxy group, or a halogen atom.

The ratio of the hydrolyzable silane represented by the formula (A) in the hydrolyzable silane (Si-1) when the hydrolyzable silane (Si-1) is hydrolytically condensed to obtain a polysiloxane is 30 mol% or more, preferably 45 mol% or more, and more preferably 60 mol% or more.

The upper limit value of the ratio of the hydrolyzable silane represented by the formula (A) in the hydrolyzable silane (Si-1) when the hydrolyzable silane (Si-1) is hydrolytically condensed to obtain the polysiloxane is not particularly limited, and the ratio may be, for example, 100 mol% or less, 90 mol% or less, or 85 mol% or less.

R in the formula (A) is a hydrolyzable group.

Examples of the alkoxy group for R in the formula (A) include alkoxy groups having 1 to 4 carbon atoms.

The aralkyloxy group in R in the formula (A) is a monovalent group derived by removing a hydrogen atom from a hydroxy group of aralkyl alcohol.

The number of carbon atoms of the aralkyloxy group is not particularly limited, but may be, for example, 40 or less, preferably 30 or less, and more preferably 20 or less.

Specific examples of the aralkyloxy group include, but are not limited to, a phenylmethyloxy group (benzyloxy group), 2-phenylethyleneoxy group, 3-phenyl-n-propyloxy group, 4-phenyl-n-butyloxy group, 5-phenyl-n-pentyloxy group, 6-phenyl-n-hexyloxy group, 7-phenyl-n-heptyloxy group, 8-phenyl-n-octyloxy group, 9-phenyl-n-nonyloxy group, and 10-phenyl-n-decyloxy group.

The acyloxy group in R in the formula (A) is a monovalent group derived by removing a hydrogen atom from a carboxyl group (-COOH) of a carboxylic acid compound, and examples of the acyloxy group typically include, but are not limited to, alkylcarbonyloxy group, arylcarbonyloxy group, or aralkylcarbonyloxy group, derived by removing a hydrogen atom from a carboxyl group of an alkyl carboxylic acid, an aryl carboxylic acid, or an aralkyl carboxylic acid.

Specific examples of the acyloxy group include an acyloxy group having 2 to 20 carbon atoms, and examples thereof include a methylcarbonyloxy group, ethylcarbonyloxy group, n-propylcarbonyloxy group, i-propylcarbonyloxy group, n-butylcarbonyloxy group, i-butylcarbonyloxy group, s-butylcarbonyloxy group, t-butylcarbonyloxy group, n-pentylcarbonyloxy group, 1-methyl-n-butylcarbonyloxy group, 2-methyl-n-butylcarbonyloxy group, 3-methyl-n-butylcarbonyloxy group, 1,1-dimethyl-n-propylcarbonyloxy group, 1,2-dimethyl-n-propylcarbonyloxy group, 2,2-dimethyl-n-propylcarbonyloxy group, 1-ethyl-n-propylcarbonyloxy group, n-hexylcarbonyloxy group, 1-methyl-n-pentylcarbonyloxy group, 2-methyl-n-pentylcarbonyloxy group, 3-methyl-n-pentylcarbonyloxy group, 4-methyl-n-pentylcarbonyloxy group, 1,1-dimethyl-n-butylcarbonyloxy group, 1,2-dimethyl-n-butylcarbonyloxy group, 1,3-dimethyl-n-butylcarbonyloxy group, 2,2-dimethyl-n-butylcarbonyloxy group, 2,3-dimethyl-n-butylcarbonyloxy group, 3,3-dimethyl-n-butylcarbonyloxy group, 1-ethyl-n-butylcarbonyloxy group, 2-ethyl-n-butylcarbonyloxy group, 1,1,2-trimethyl-n-propylcarbonyloxy group, 1,2,2-trimethyl-n-propylcarbonyloxy group, 1-ethyl-1-methyl-n-propylcarbonyloxy group, 1-ethyl-2-methyl-n-propylcarbonyloxy group, phenylcarbonyloxy group, and tosylcarbonyloxy group.

Examples of the halogen atom in R in the formula (A) include a fluorine atom, a chlorine atom, a bromine atom, and an iodine atom.

Among these, R is preferably an alkoxy group, and more preferably an alkoxy group having 1 to 4 carbon atoms.

As the hydrolyzable silane represented by the formula (A), specific examples of the hydrolyzable silane represented by the formula (1) include tetramethoxysilane, tetrachlorosilane, tetraacetoxysilane, tetraethoxysilane, tetra-n-propoxysilane, tetra-i-propoxysilane, and tetra-n-butoxysilane.

The hydrolyzable silane (Si-1) preferably further includes a hydrolyzable silane represented by the following formula (B).
[Chem. 5]

**R¹¹ₐSi(R¹²)₄₋ₐ** **(B)**

In the formula (B), R¹¹ represents a group bonded to a silicon atom, and each independently represents an organic group having a number of carbon atoms of 1 to 45,
R¹² is a group or atom bonded to a silicon atom, and each independently represents an alkoxy group, an aralkyloxy group, an acyloxy group, or a halogen atom, and
a represents an integer of 1 to 3.

a is preferably 1 or 2, and more preferably 1.

### <<R¹² in formula (B)>>

R¹² in the formula (B) is a group or atom bonded to a silicon atom, and each independently represents an alkoxy group, an aralkyloxy group, an acyloxy group, or a halogen atom.

Specific examples and preferable examples of R¹² in the formula (B) include the specific examples and preferable examples given in the description of R in the formula (A).

### <<R¹¹ in formula (B)>>

R¹¹ in the formula (B) represents a group bonded to a silicon atom, and each independently represents an organic group having 1 to 45 carbon atoms.

R¹¹ in the formula (B) is not a hydrolyzable group.

Examples of R¹¹ in the formula (B) include an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group, an optionally substituted alkoxyaralkyl group, an optionally substituted alkenyl group, an organic group having a cyclic urea skeleton, an organic group having an optionally ring-opened epoxy group, an organic group having an acryloyl group, an organic group having a methacryloyl group, an organic group having a mercapto group, an organic group having an amino group, an organic group having an alkoxy group, an organic group having a sulfonyl group, an organic group having a cyano group, or combinations of two or more thereof.

The alkyl group may be linear, branched, or cyclic, and the number of carbon atoms thereof is not particularly limited, but is preferably 40 or less, more preferably 30 or less, still more preferably 20 or less, and even more preferably 10 or less.

Specific examples of the linear or branched alkyl group as the alkyl group include a methyl group, ethyl group, n-propyl group, i-propyl group, n-butyl group, i-butyl group, s-butyl group, t-butyl group, n-pentyl group, 1-methyl-n-butyl group, 2-methyl-n-butyl group, 3-methyl-n-butyl group, 1,1-dimethyl-n-propyl group, 1,2-dimethyl-n-propyl group, 2,2-dimethyl-n-propyl group, 1-ethyl-n-propyl group, n-hexyl group, 1-methyl-n-pentyl group, 2-methyl-n-pentyl group, 3-methyl-n-pentyl group, 4-methyl-n-pentyl group, 1,1-dimethyl-n-butyl group, 1,2-dimethyl-n-butyl group, 1,3-dimethyl-n-butyl group, 2,2-dimethyl-n-butyl group, 2,3-dimethyl-n-butyl group, 3,3-dimethyl-n-butyl group, 1-ethyl-n-butyl group, 2-ethyl-n-butyl group, 1,1,2-trimethyl-n-propyl group, 1,2,2-trimethyl-n-propyl group, 1-ethyl-1-methyl-n-propyl group, and 1-ethyl-2-methyl-n-propyl group.

In the present specification, "i" means "iso", "s" means "sec", and "t" means "tert".

Specific examples of the cyclic alkyl group include: cyclic alkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and crosslinked cyclic cycloalkyl groups, such as a bicyclobutyl group, a bicyclopentyl group, a bicyclohexyl group, a bicycloheptyl group, a bicyclooctyl group, a bicyclononyl group, and a bicyclodecyl group.

The aryl group may be any of a phenyl group, a monovalent group derived by removing one hydrogen atom from a condensed-ring aromatic hydrocarbon compound, and a monovalent group derived by removing one hydrogen atom from a linked-ring aromatic hydrocarbon compound. The number of carbon atoms of the aryl group is not particularly limited, but is preferably 40 or less, more preferably 30 or less, and still more preferably 20 or less.

Examples of the aryl group include an aryl group having 6 to 20 carbon atoms, and examples thereof include, but are not limited thereto, a phenyl group, a 1-naphthyl group, a 2-naphthyl group, a 1-anthryl group, a 2-anthryl group, a 9-anthryl group, a 1-phenanthryl group, a 2-phenanthryl group, a 3-phenanthryl group, a 4-phenanthryl group, a 9-phenanthryl group, a 1-naphthacenyl group, a 2-naphthacenyl group, a 5-naphthacenyl group, a 2-chrysenyl group, a 1-pyrenyl group, a 2-pyrenyl group, a pentacenyl group, a benzopyrenyl group, and a triphenylenyl group; a biphenyl-2-yl group (o-biphenylyl group), a biphenyl-3-yl group (m-biphenylyl group), a biphenyl-4-yl group (p-biphenylyl group), a paraterphenyl-4-yl group, a metaterphenyl-4-yl group, an orthoterphenyl-4-yl group, a 1,1'-binaphthyl-2-yl group, and a 2,2'-binaphthyl-1-yl group.

The aralkyl group is an alkyl group substituted with an aryl group, and specific examples of the aryl group and the alkyl group are the same as those described above. The number of carbon atoms of the aralkyl group is not particularly limited, but is preferably 40 or less, more preferably 30 or less, and still more preferably 20 or less.

Specific examples of the aralkyl group include, but are not limited to, phenylmethyl group (benzyl group), 2-phenylethylene group, 3-phenyl-n-propyl group, 4-phenyl-n-butyl group, 5-phenyl-n-pentyl group, 6-phenyl-n-hexyl group, 7-phenyl-n-heptyl group, 8-phenyl-n-octyl group, 9-phenyl-n-nonyl group, and 10-phenyl-n-decyl group.

The alkyl halide group, the aryl halide group, and the aralkyl halide group are an alkyl group substituted with one or more halogen atoms, an aryl group substituted with one or more halogen atoms, and an aralkyl group substituted with one or more halogen atoms, respectively. Specific examples of the alkyl group, the aryl group, and the aralkyl group are the same as those described above.

The number of carbon atoms of the alkyl halide group is not particularly limited, but is preferably 40 or less, more preferably 30 or less, still more preferably 20 or less, and yet still more preferably 10 or less.

Specific examples of the alkyl halide group include, but are not limited to, monofluoromethyl group, difluoromethyl group, trifluoromethyl group, bromodifluoromethyl group, 2-chloroethyl group, 2-bromoethyl group, 1,1-difluoroethyl group, 2,2,2-trifluoroethyl group, 1,1,2,2-tetrafluoroethyl group, 2-chloro-1,1,2-trifluoroethyl group, pentafluoroethyl group, 3-bromopropyl group, 2,2,3,3-tetrafluoropropyl group, 1,1,2,3,3,3-hexafluoropropyl group, 1,1,1,3,3,3-hexafluoropropane-2-yl group, 3-bromo-2-methylpropyl group, 4-bromobutyl group, and perfluoropentyl group.

The number of carbon atoms of the aryl halide group is not particularly limited, but is preferably 40 or less, more preferably 30 or less, and still more preferably 20 or less.

Specific examples of the aryl halide group include 2-fluorophenyl group, 3-fluorophenyl group, 4-fluorophenyl group, 2,3-difluorophenyl group, 2,4-difluorophenyl group, 2,5-difluorophenyl group, 2,6-difluorophenyl group, 3,4-difluorophenyl group, 3,5-difluorophenyl group, 2,3,4-trifluorophenyl group, 2,3,5-trifluorophenyl group, 2,3,6-trifluorophenyl group, 2,4,5-trifluorophenyl group, 2,4,6-trifluorophenyl group, 3,4,5-trifluorophenyl group, 2,3,4,5-tetrafluorophenyl group, 2,3,4,6-tetrafluorophenyl group, 2,3,5,6-tetrafluorophenyl group, pentafluorophenyl group, 2-fluoro-1-naphthyl group, 3-fluoro-1-naphthyl group, 4-fluoro-1-naphthyl group, 6-fluoro-1-naphthyl group, 7-fluoro-1-naphthyl group, 8-fluoro-1-naphthyl group, 4,5-difluoro-1-naphthyl group, 5,7-difluoro-1-naphthyl group, 5,8-difluoro-1-naphthyl group, 5,6,7,8-tetrafluoro-1-naphthyl group, heptafluoro-1-naphthyl group, 1-fluoro-2-naphthyl group, 5-fluoro-2-naphthyl group, 6-fluoro-2-naphthyl group, 7-fluoro-2-naphthyl group, 5,7-difluoro-2-naphthyl group, and heptafluoro-2-naphthyl group. Examples thereof also include groups in which fluorine atoms (fluoro groups) in the above groups are optionally substituted with chlorine atoms (chloro groups), bromine atoms (bromo groups), or iodine atoms (iodo groups), but not limited thereto.

The number of carbon atoms of the aralkyl halide group is not particularly limited, but is preferably 40 or less, more preferably 30 or less, and still more preferably 20 or less.

Specific examples of the aralkyl halide group include 2-fluorobenzyl group, 3-fluorobenzyl group, 4-fluorobenzyl group, 2,3-difluorobenzyl group, 2,4-difluorobenzyl group, 2,5-difluorobenzyl group, 2,6-difluorobenzyl group, 3,4-difluorobenzyl group, 3,5-difluorobenzyl group, 2,3,4-trifluorobenzyl group, 2,3,5-trifluorobenzyl group, 2,3,6-trifluorobenzyl group, 2,4,5-trifluorobenzyl group, 2,4,6-trifluorobenzyl group, 2,3,4,5-tetrafluorobenzyl group, 2,3,4,6-tetrafluorobenzyl group, 2,3,5,6-tetrafluorobenzyl group, and 2,3,4,5,6-pentafluorobenzyl group. Examples thereof also include groups in which fluorine atoms (fluoro groups) in the above groups are optionally substituted with chlorine atoms (chloro groups), bromine atoms (bromo groups), or iodine atoms (iodo groups), but not limited thereto.

The alkoxyalkyl group, the alkoxyaryl group, and the alkoxyaralkyl group are an alkyl group substituted with one or more alkoxy groups, an aryl group substituted with one or more alkoxy groups, and an aralkyl group substituted with one or more alkoxy groups, respectively. Specific examples of the alkoxyalkyl group, the alkoxyaryl group, and the alkoxyaralkyl group are the same as those described above.

The alkoxy group as the substituent is, for example, an alkoxy group having at least any one of linear, branched, and cyclic alkyl moieties having 1 to 20 carbon atoms.

Examples of the linear or branched alkoxy group include a methoxy group, an ethoxy group, an n-propoxy group, an i-propoxy group, an n-butoxy group, an i-butoxy group, an s-butoxy group, a t-butoxy group, an n-pentyloxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, an n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, and a 1-ethyl-2-methyl-n-propoxy group.

Examples of the cyclic alkoxy group include a cyclopropoxy group, a cyclobutoxy group, a 1-methyl-cyclopropoxy group, a 2-methyl-cyclopropoxy group, a cyclopentyloxy group, a 1-methyl-cyclobutoxy group, a 2-methyl-cyclobutoxy group, a 3-methyl-cyclobutoxy group, a 1,2-dimethyl-cyclopropoxy group, a 2,3-dimethyl-cyclopropoxy group, a 1-ethyl-cyclopropoxy group, a 2-ethyl-cyclopropoxy group, a cyclohexyloxy group, a 1-methyl-cyclopentyloxy group, a 2-methyl-cyclopentyloxy group, a 3-methyl-cyclopentyloxy group, a 1-ethyl-cyclobutoxy group, a 2-ethyl-cyclobutoxy group, a 3-ethyl-cyclobutoxy group, a 1,2-dimethyl-cyclobutoxy group, a 1,3-dimethyl-cyclobutoxy group, a 2,2-dimethyl-cyclobutoxy group, a 2,3-dimethyl-cyclobutoxy group, a 2,4-dimethyl-cyclobutoxy group, a 3,3-dimethyl-cyclobutoxy group, a 1-n-propyl-cyclopropoxy group, a 2-n-propyl-cyclopropoxy group, a 1-i-propyl-cyclopropoxy group, a 2-i-propyl-cyclopropoxy group, a 1,2,2-trimethyl-cyclopropoxy group, a 1,2,3-trimethyl-cyclopropoxy group, a 2,2,3-trimethyl-cyclopropoxy group, a 1-ethyl-2-methyl-cyclopropoxy group, a 2-ethyl-1-methyl-cyclopropoxy group, a 2-ethyl-2-methyl-cyclopropoxy group, and a 2-ethyl-3-methyl-cyclopropoxy group.

Specific examples of the alkoxyalkyl group include, but are not limited to, lower (about 5 or less carbon atoms) alkyloxy lower (about 5 or less carbon atoms) alkyl groups, such as methoxymethyl group, ethoxymethyl group, 1-ethoxyethyl group, 2-ethoxyethyl group, and ethoxymethyl group.

Specific examples of the alkoxyaryl group include, but are not limited to, a 2-methoxyphenyl group, 3-methoxyphenyl group, 4-methoxyphenyl group, 2-(1-ethoxy)phenyl group, 3-(1-ethoxy)phenyl group, 4-(1-ethoxy)phenyl group, 2-(2-ethoxy)phenyl group, 3-(2-ethoxy)phenyl group, 4-(2-ethoxy)phenyl group, 2-methoxynaphthalene-1-yl group, 3-methoxynaphthalene-1-yl group, 4-methoxynaphthalene-1-yl group, 5-methoxynaphthalene-1-yl group, 6-methoxynaphthalene-1-yl group, and 7-methoxynaphthalene-1-yl group.

Specific examples of the alkoxyaralkyl group include, but are not limited to, a 3-(methoxyphenyl)benzyl group and a 4-(methoxyphenyl)benzyl group.

The alkenyl group may be linear or branched, and the number of carbon atoms of the linear or branched alkenyl group is not particularly limited, but is preferably 40 or less, more preferably 30 or less, still more preferably 20 or less, and yet still more preferably 10 or less.

Specific examples of the alkenyl group include an ethenyl group (vinyl group), 1-propenyl group, 2-propenyl group, 1-methyl-1-ethenyl group, 1-butenyl group, 2-butenyl group, 3-butenyl group, 2-methyl-1-propenyl group, 2-methyl-2-propenyl group, 1-ethylethenyl group, 1-methyl-1-propenyl group, 1-methyl-2-propenyl group, 1-pentenyl group, 2-pentenyl group, 3-pentenyl group, 4-pentenyl group, 1-n-propylethenyl group, 1-methyl-1-butenyl group, 1-methyl-2-butenyl group, 1-methyl-3-butenyl group, 2-ethyl-2-propenyl group, 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, 1,2-dimethyl-1-propenyl group, 1,2-dimethyl-2-propenyl group, 1-cyclopentenyl group, 2-cyclopentenyl group, 3-cyclopentenyl group, 1-hexenyl group, 2-hexenyl group, 3-hexenyl group, 4-hexenyl group, 5-hexenyl group, 1-methyl-1-pentenyl group, 1-methyl-2-pentenyl group, 1-methyl-3-pentenyl group, 1-methyl-4-pentenyl group, 1-n-butylethenyl group, 2-methyl-1-pentenyl group, 2-methyl-2-pentenyl group, 2-methyl-3-pentenyl group, 2-methyl-4-pentenyl group, 2-n-propyl-2-propenyl group, 3-methyl-1-pentenyl group, 3-methyl-2-pentenyl group, 3-methyl-3-pentenyl group, 3-methyl-4-pentenyl group, 3-ethyl-3-butenyl group, 4-methyl-1-pentenyl group, 4-methyl-2-pentenyl group, 4-methyl-3-pentenyl group, 4-methyl-4-pentenyl group, 1,1-dimethyl-2-butenyl group, 1,1-dimethyl-3-butenyl group, 1,2-dimethyl-1-butenyl group, 1,2-dimethyl-2-butenyl group, 1,2-dimethyl-3-butenyl group, 1-methyl-2-ethyl-2-propenyl group, 1-s-butylethenyl group, 1,3-dimethyl-1-butenyl group, 1,3-dimethyl-2-butenyl group, 1,3-dimethyl-3-butenyl group, 1-i-butylethenyl group, 2,2-dimethyl-3-butenyl group, 2,3-dimethyl-1-butenyl group, 2,3-dimethyl-2-butenyl group, 2,3-dimethyl-3-butenyl group, 2-i-propyl-2-propenyl group, 3,3-dimethyl-1-butenyl group, 1-ethyl-1-butenyl group, 1-ethyl-2-butenyl group, 1-ethyl-3-butenyl group, 1-n-propyl-1-propenyl group, 1-n-propyl-2-propenyl group, 2-ethyl-1-butenyl group, 2-ethyl-2-butenyl group, 2-ethyl-3-butenyl group, 1,1,2-trimethyl-2-propenyl group, 1-t-butylethenyl group, 1-methyl-1-ethyl-2-propenyl group, 1-ethyl-2-methyl-1-propenyl group, 1-ethyl-2-methyl-2-propenyl group, 1-i-propyl-1-propenyl group, 1-i-propyl-2-propenyl group, 1-methyl-2-cyclopentenyl group, 1-methyl-3-cyclopentenyl group, 2-methyl-1-cyclopentenyl group, 2-methyl-2-cyclopentenyl group, 2-methyl-3-cyclopentenyl group, 2-methyl-4-cyclopentenyl group, 2-methyl-5-cyclopentenyl group, 2-methylene-cyclopentyl group, 3-methyl-1-cyclopentenyl group, 3-methyl-2-cyclopentenyl group, 3-methyl-3-cyclopentenyl group, 3-methyl-4-cyclopentenyl group, 3-methyl-5-cyclopentenyl group, 3-methylene-cyclopentyl group, 1-cyclohexenyl group, 2-cyclohexenyl group, and 3-cyclohexenyl group. Examples thereof also include crosslinked cyclic alkenyl groups such as a bicycloheptenyl group (norbornyl group).

Examples of the substituent in the aforementioned alkyl group, aryl group, aralkyl group, alkyl halide group, aryl halide group, aralkyl halide group, alkoxyalkyl group, alkoxyaryl group, alkoxyaralkyl group, and alkenyl group described above include an alkyl group, an aryl group, an aralkyl group, an alkyl halide group, an aryl halide group, an aralkyl halide group, an alkoxyalkyl group, an aryloxy group, an alkoxyaryl group, an alkoxyaralkyl group, an alkenyl group, an alkoxy group, and an aralkyloxy group. Specific examples thereof and the preferred number of carbon atoms thereof are the same as those described above or below.

The aryloxy group as described in the substituent is a group in which an aryl group is bonded via an oxygen atom (-O-), and specific examples of the aryl group are the same as those described above. The number of carbon atoms in the aryloxy group is not particularly limited, but is preferably 40 or less, more preferably 30 or less, and still more preferably 20 or less. Specific examples thereof include, but are not limited to, a phenoxy group and a naphthalen-2-yloxy group.

When two or more substituents are present, the substituents may be bonded together to form a ring.

Examples of the organic group having an optionally ring-opened epoxy group include a glycidoxymethyl group, a glycidoxyethyl group, a glycidoxypropyl group, a glycidoxybutyl group, an epoxy cyclohexyl group, and groups in which epoxy groups of the above groups are ring-opened.

Examples of the organic group having an acryloyl group include an acryloyloxymethyl group, an acryloyloxyethyl group, and an acryloyloxypropyl group.

Examples of the organic group having a methacryloyl group include a methacryloyloxymethyl group, a methacryloyloxyethyl group, and a methacryloyloxypropyl group.

Examples of the organic group having a mercapto group include a mercaptoethyl group, a mercaptobutyl group, a mercaptohexyl group, a mercaptooctyl group, and a mercaptophenyl group.

Examples of the organic group having an amino group include, but are not limited to, an amino group, an aminomethyl group, an aminoethyl group, an aminophenyl group, a dimethylaminoethyl group, and a dimethylaminopropyl group. The organic group having an amino group will be described later in more detail.

Examples of the organic group having an alkoxy group include, but are not limited to, methoxymethyl group and methoxyethyl group. However, the organic group excludes a group in which an alkoxy group is directly bonded to a silicon atom.

Examples of the organic group having a sulfonyl group include, but are not limited to, a sulfonylalkyl group and a sulfonylaryl group.

Examples of the organic group having a cyano group include a cyanoethyl group, a cyanopropyl group, a cyanophenyl group, and a thiocyanate group.

The organic group having an amino group is, for example, an organic group having at least one of a primary amino group, a secondary amino group, or a tertiary amino group. A hydrolysis condensate in which a hydrolyzable silane having a tertiary amino group is hydrolyzed with a strong acid to form a counter cation having a tertiary ammonium group can be preferably used. The organic group may contain a heteroatom such as an oxygen atom or a sulfur atom, in addition to the nitrogen atom forming the amino group.

A preferable example of the organic group having an amino group is a group represented by the following formula (A1).

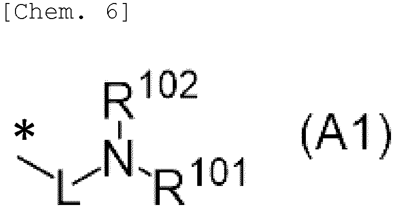

In the formula (A1), R¹⁰¹ and R¹⁰² each independently represent a hydrogen atom or a hydrocarbon group, and L represents an independently and optionally substituted alkylene group. * represents a bonding site.

Examples of the hydrocarbon group include, but are not limited to, an alkyl group, an alkenyl group, and an aryl group. Specific examples of the alkyl group, the alkenyl group, and the aryl group are the same as those described above regarding R¹.

The alkylene group may be linear or branched, and the number of carbon atoms of the linear or branched alkylene group is ordinarily 1 to 10, preferably 1 to 5. Examples of the linear or branched alkylene group include linear alkylene groups such as a methylene group, an ethylene group, a trimethylene group, a tetramethylene group, a pentamethylene group, a hexamethylene group, a heptamethylene group, an octamethylene group, a nonamethylene group, and a decamethylene group.

Examples of the organic group having an amino group include, but are not limited to, an amino group, an aminomethyl group, an aminoethyl group, an aminophenyl group, a dimethylaminoethyl group, and a dimethylaminopropyl group.

Examples of the organic group having a cyclic urea skeleton include an organic group represented by the following formula (4-2).

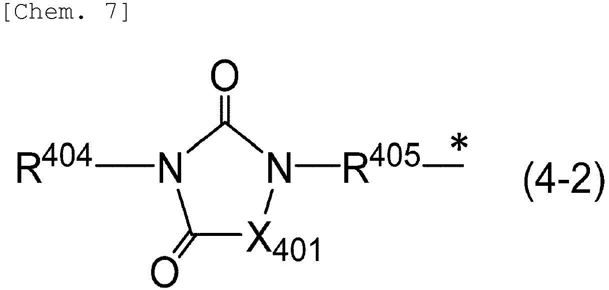

In the formula (4-2), R⁴⁰⁴ each independently represents a hydrogen atom, an optionally substituted alkyl group, an optionally substituted alkenyl group, or an organic group having an epoxy group or an organic group having a sulfonyl group, and R⁴⁰⁵ each independently represents an alkylene group, a hydroxyalkylene group, a sulfide bond (-S-), an ether bond (-O-), or an ester bond (-CO-O- or -O-CO-). * represents a bonding site.

Specific examples and preferred carbon numbers of the organic group having an optionally substituted alkyl group, an optionally substituted alkenyl group, and an epoxy group of R⁴⁰⁴ are the same as those described above for R¹².

In addition, the alkylene group of R⁴⁰⁵ may have one or more types of bonds selected from a sulfide bond, an ether bond, and an ester bond at terminal ends or in the middle, and preferably in the middle.

Specific examples of the alkylene group include, but are not limited to, linear alkylene groups such as a methylene group, an ethylene group, a trimethylene group, a tetramethylene group, a pentamethylene group, a hexamethylene group, a heptamethylene group, an octamethylene group, a nonamethylene group, and a decamethylene group; branched alkylene groups such as a methylethylene group, a 1-methyltrimethylene group, a 2-methyltrimethylene group, a 1,1-dimethylethylene group, a 1-methyltetramethylene group, a 2-methyltetramethylene group, a 1,1-dimethyltrimethylene group, a 1,2-dimethyltrimethylene group, a 2,2-dimethyltrimethylene group, and a 1-ethyltrimethylene group; cyclic alkylene groups such as a 1,2-cyclopropanediyl group, a 1,2-cyclobutanediyl group, a 1,3-cyclobutanediyl group, a 1,2-cyclohexanediyl group, and a 1,3-cyclohexanediyl group; and alkylene groups containing ether groups such as -CH₂OCH₂-, -CH₂CH₂OCH₂-, -CH₂CH₂OCH₂CH₂-, -CH₂CH₂CH₂OCH₂CH₂-, - CH₂CH₂OCH₂CH₂CH₂-, -CH₂CH₂CH₂OCH₂CH₂CH₂-, -CH₂SCH₂-, - CH₂CH₂SCH₂-, -CH₂CH₂SCH₂CH₂-, -CH₂CH₂CH₂SCH₂CH₂-, - CH₂CH₂SCH₂CH₂CH₂-, -CH₂CH₂CH₂SCH₂CH₂CH₂-, and -CH₂OCH₂CH₂SCH₂-.

The hydroxyalkylene group is a group in which at least one hydrogen atom of the above-described alkylene group is replaced with a hydroxy group. Specific examples of the hydroxyalkylene group include, but are not limited to, a hydroxymethylene group, a 1-hydroxyethylene group, a 2-hydroxyethylene group, a 1,2-dihydroxyethylene group, a 1-hydroxytrimethylene group, a 2-hydroxytrimethylene group, a 3-hydroxytrimethylene group, a 1-hydroxytetramethylene group, a 2-hydroxytetramethylene group, a 3-hydroxytetramethylene group, a 4-hydroxytetramethylene group, a 1,2-dihydroxytetramethylene group, a 1,3-dihydroxytetramethylene group, a 1,4-dihydroxytetramethylene group, a 2,3-dihydroxytetramethylene group, a 2,4-dihydroxytetramethylene group, and a 4,4-dihydroxytetramethylene group.

In the formula (4-2), X₄₀₁ each independently represents any one of groups represented by the following formulae (4-3) to (4-5), and a carbon atom of a ketone group in the following formulae (4-4) and (4-5) is bonded to a nitrogen atom to which R⁴⁰⁵ in the formula (4-2) is bonded.

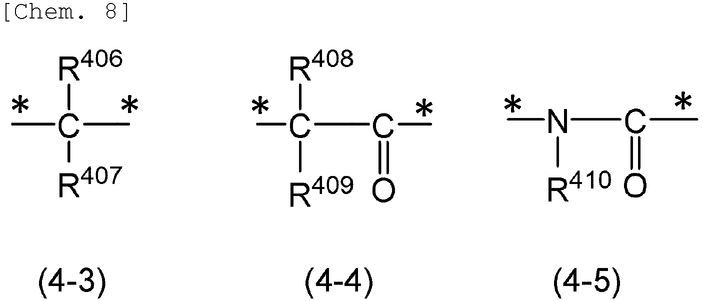

In the formulae (4-3) to (4-5), R⁴⁰⁶ to R⁴¹⁰ each independently represents a hydrogen atom, an optionally substituted alkyl group, an optionally substituted alkenyl group, or an organic group having an epoxy group or a sulfonyl group. Specific examples of the optionally substituted alkyl group, the optionally substituted alkenyl group, and the organic group having an epoxy group or a sulfonyl group, and the preferred number of carbon atoms thereof are the same as those described above regarding R¹². Specific examples of the organic group having a sulfonyl group and the preferred number of carbon atoms are the same as those described above regarding R⁴⁰⁴. * represents a bonding site.

As the hydrolyzable silane having an organic group having a cyclic urea skeleton, a commercially available product may be used, and the hydrolyzable silane can also be synthesized by a known method described in WO 2011/102470 A or the like.

Specific examples of the hydrolyzable silane having an organic group having a cyclic urea skeleton include silanes represented by the following formulae (4-1-1) to (4-1-29), but are not limited thereto.

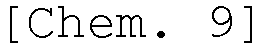

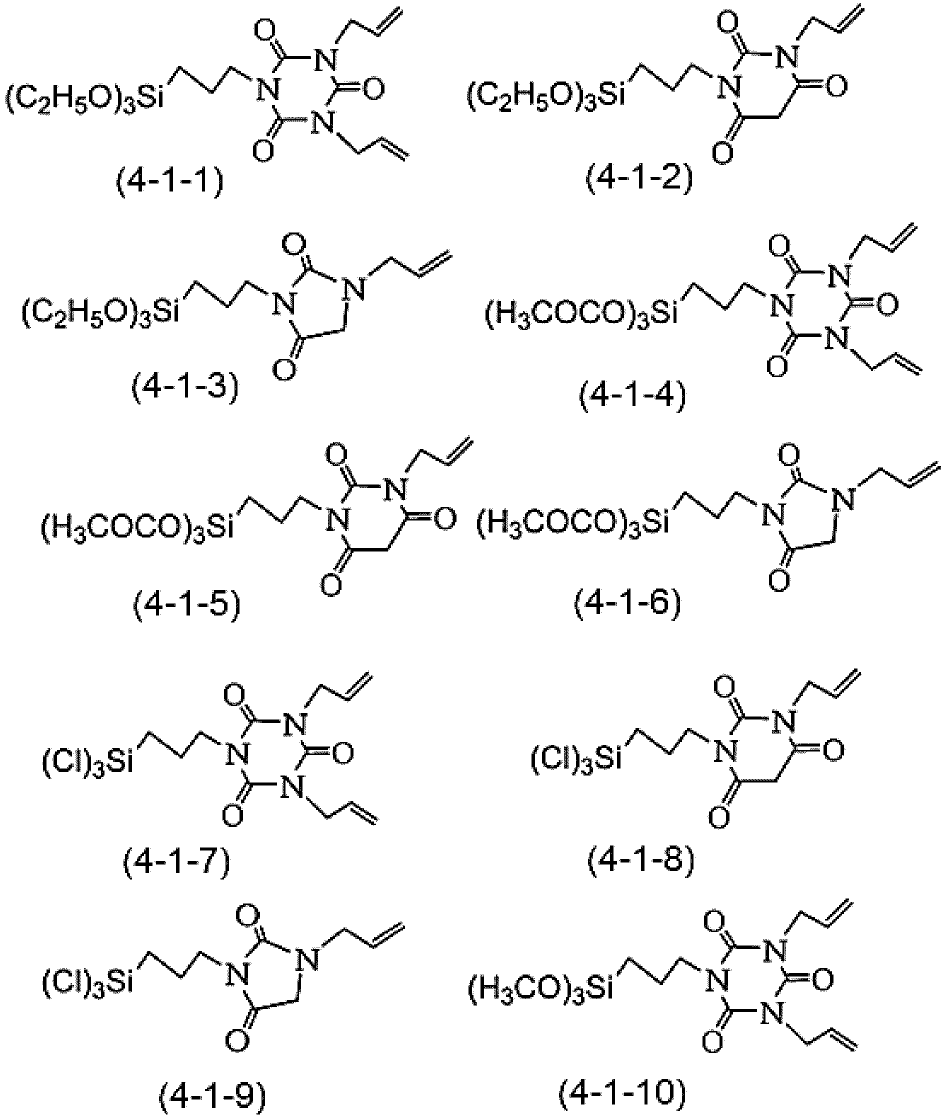

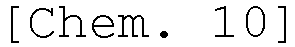

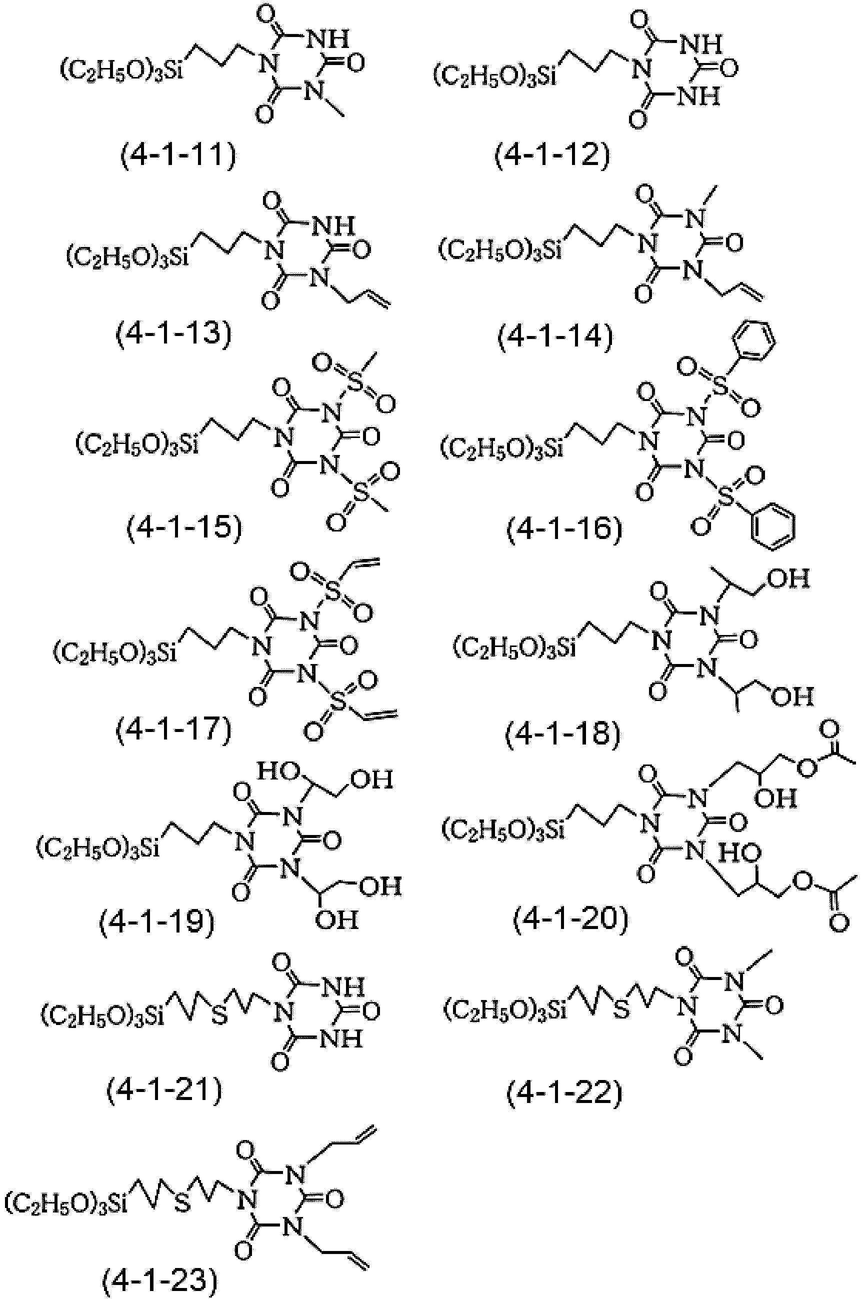

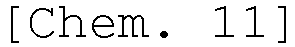

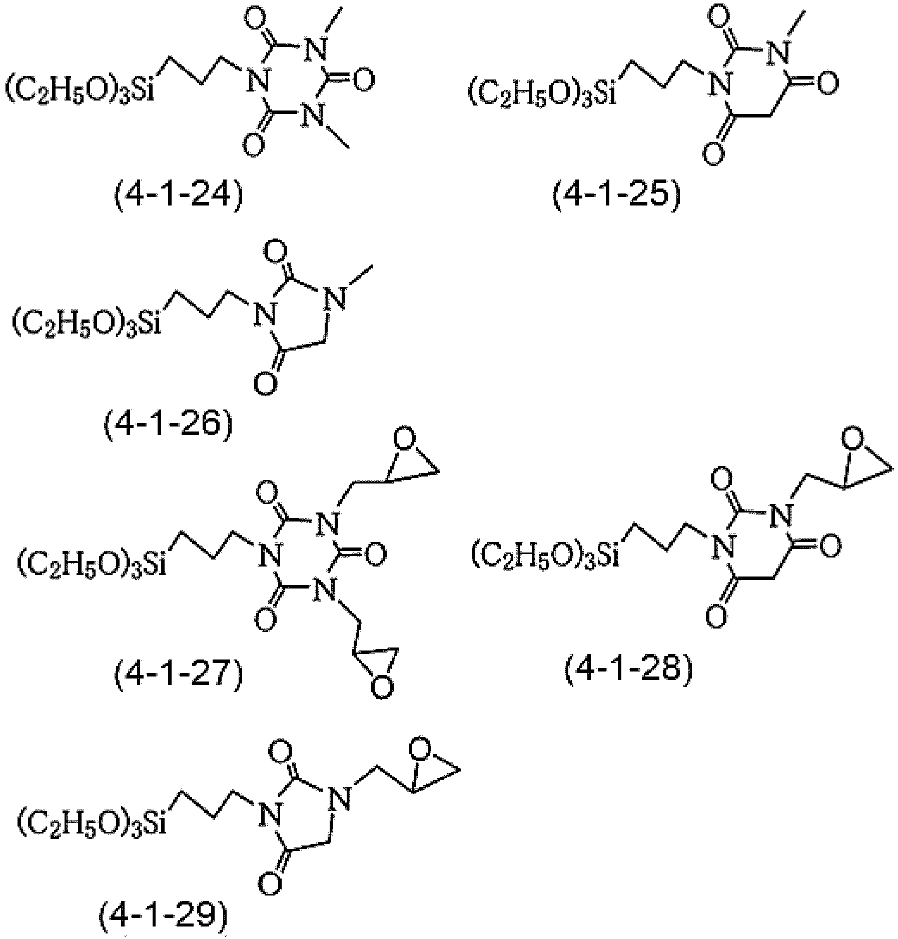

The ratio of the hydrolyzable silane represented by the formula (B) in the hydrolyzable silane (Si-1) when the hydrolyzable silane (Si-1) is hydrolytically condensed to obtain a polysiloxane is preferably 5 mol% or more, more preferably 10 mol% or more, and particularly preferably 20 mol% or more.

The upper limit value of the ratio of the hydrolyzable silane represented by the formula (B) in the hydrolyzable silane (Si-1) when the hydrolyzable silane (Si-1) is hydrolytically condensed to obtain the polysiloxane is not particularly limited, and the ratio may be, for example, 70 mol% or less, 55 mol% or less, or 40 mol% or less.

The ratio of total of the hydrolyzable silane represented by the formula (A) and the hydrolyzable silane represented by the formula (B) in the hydrolyzable silane (Si-1) when the hydrolyzable silane (Si-1) is hydrolytically condensed to obtain a polysiloxane is not particularly limited, but is preferably 70 mol% to 100 mol%, more preferably 80 mol% to 100 mol%, and particularly preferably 90 mol% to 100 mol%.

The polysiloxane as the component [A] may be a hydrolysis condensate of a hydrolyzable silane (Si-1) containing a silane compound other than those exemplified above or a modified product as long as the effects of the present invention are not impaired.

As described above, as the polysiloxane that is the component [A], a modified product in which at least some of silanol groups of the hydrolysis condensate are modified can be used. For example, a modified product in which some of silanol groups are alcohol-modified or acetal-protected can be used.

Examples of the polysiloxane as the modified product include a reaction product obtained by a reaction between at least some of silanol groups and a hydroxy group of an alcohol in the hydrolysis condensate of the hydrolyzable silane described above, a dehydration reaction product between the condensate and an alcohol, and a modified product obtained by protecting at least some of silanol groups of the condensate with an acetal group.

As the alcohol, a monohydric alcohol can be used. Examples of the monohydric alcohol include methanol, ethanol, 2-propanol, 1-butanol, 2-butanol, isobutyl alcohol, tert-butyl alcohol, 1-pentanol, 2-pentanol, 3-pentanol, 1-heptanol, 2-heptanol, tert-amyl alcohol, neopentyl alcohol, 2-methyl-1-propanol, 2-methyl-1-butanol, 3-methyl-1-butanol, 3-methyl-3-pentanol, cyclopentanol, 1-hexanol, 2-hexanol, 3-hexanol, 2,3-dimethyl-2-butanol, 3,3-dimethyl-1-butanol, 3,3-dimethyl-2-butanol, 2-diethyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 4-methyl-3-pentanol, and cyclohexanol.

For example, alkoxy group-containing alcohols such as 3-methoxybutanol, ethylene glycol monomethyl ether, ethylene glycol monoethyl ether, diethylene glycol monomethyl ether, diethylene glycol monoethyl ether, propylene glycol monomethyl ether (1-methoxy-2-propanol), propylene glycol monoethyl ether (1-ethoxy-2-propanol), and propylene glycol monobutyl ether (1-butoxy-2-propanol) can be used.

The reaction between silanol groups of the hydrolysis condensate and hydroxy groups of the alcohol is performed by bringing the hydrolysis condensate into contact with the alcohol. A modified product containing capped silanol groups is prepared by performing the reaction at a temperature of 40 to 160°C (e.g. 60°C) for 0.1 to 48 hours (e.g. 24 hours). In this case, the alcohol serving as a capping agent may be used as a solvent in the composition containing the polysiloxane.

The product by dehydration reaction between the hydrolysis condensate of hydrolyzable silane and the alcohol can be produced by reacting the hydrolysis condensate with the alcohol in the presence of an acid as a catalyst, capping silanol groups with the alcohol, and removing water generated through the dehydration to the outside of the reaction system.

The acid may be an organic acid having an acid dissociation constant (pKa) of -1 to 5, preferably 4 to 5. Examples of the acid include trifluoroacetic acid, maleic acid, benzoic acid, isobutyric acid, and acetic acid. In particular, benzoic acid, isobutyric acid, and acetic acid can be exemplified.

As the acid, an acid having a boiling point of 70 to 160°C may be used. Examples of the acid include trifluoroacetic acid, isobutyric acid, acetic acid, and nitric acid.

Preferably, the acid described above has either an acid dissociation constant (pKa) of 4 to 5 or a boiling point of 70 to 160°C. That is, the acid to be used may be an acid having a weak acidity, or an acid having a strong acidity and a low boiling point.

Either of these properties: acid dissociation constant and boiling point of the acid may be utilized.

The acetal protection of silanol groups of the hydrolysis condensate can be performed with a vinyl ether; for example, a vinyl ether represented by the following formula (5). Such a reaction can be performed to introduce a partial structure represented by the following formula (6) into the polysiloxane.

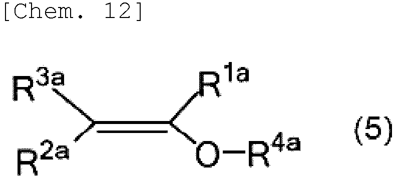

In the formula (5), R^{1a}, R^{2a}, and R^{3a} each represent a hydrogen atom or an alkyl group having 1 to 10 carbon atoms, R^{4a} represents an alkyl group having 1 to 10 carbon atoms, and R^{2a} and R^{4a} may be bonded together to form a ring. Examples of the alkyl group include the examples described above.

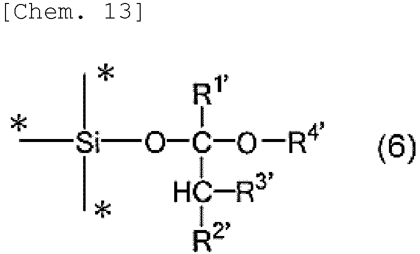

In the formula (6), R¹', R²', and R³' each represent a hydrogen atom or an alkyl group having 1 to 10 carbon atoms, R⁴' represents an alkyl group having 1 to 10 carbon atoms, and R²' and R⁴' may be bonded together to form a ring. In the formula (6), each asterisk * represents a bond to an adjacent atom. The adjacent atom is, for example, an oxygen atom of a siloxane bond, an oxygen atom of a silanol group, or a carbon atom derived from R¹ of the formula (1). Examples of the alkyl group include the examples described above.

As the vinyl ether represented by the formula (5), for example, aliphatic vinyl ether compounds, such as methyl vinyl ether, ethyl vinyl ether, isopropyl vinyl ether, normal butyl vinyl ether, 2-ethylhexyl vinyl ether, tert-butyl vinyl ether, and cyclohexyl vinyl ether; and cyclic vinyl ether compounds, such as 2,3-dihydrofuran, 4-methyl-2,3-dihydrofuran, and 3,4-dihydro-2H-pyran, may be used. In particular, ethyl vinyl ether, propyl vinyl ether, butyl vinyl ether, ethylhexyl vinyl ether, cyclohexyl vinyl ether, 3,4-dihydro-2H-pyran, or 2,3-dihydrofuran may be preferably used.

The acetal protection of the silanol group can be performed using a hydrolysis condensate, a vinyl ether, and an aprotic solvent such as propylene glycol monomethyl ether acetate, ethyl acetate, dimethylformamide, tetrahydrofuran, or 1,4-dioxane as a solvent, and using a catalyst such as a pyridinium para-toluenesulfonic acid, a trifluoromethanesulfonic acid, a para-toluenesulfonic acid, a methanesulfonic acid, a hydrochloric acid, or a sulfuric acid.

The capping of silanol groups with an alcohol or the acetal protection of silanol groups may be performed simultaneously with the hydrolysis and condensation of the hydrolyzable silane described below.

The hydrolysis condensate of hydrolyzable silane is prepared by hydrolysis and condensation of the above-described silane compound (hydrolyzable silane).

The above-described silane compound (hydrolyzable silane) contains an alkoxy group, aralkyloxy group, acyloxy group, or halogen atom directly bonded to a silicon atom; i.e. an alkoxysilyl group, an aralkyloxysilyl group, an acyloxysilyl group, or a silyl halide group (hereinafter, such a group is referred to as "hydrolyzable group").

For the hydrolysis of the hydrolyzable group, ordinarily 0.1 to 100 mol, for example, 0.5 to 100 mol, preferably 1 to 10 mol, of water is used per mol of the hydrolyzable group.

During hydrolysis and condensation, a hydrolysis catalyst may be used for the purpose of promoting the reaction. Alternatively, the hydrolysis and condensation may be performed without use of a hydrolysis catalyst. When a hydrolysis catalyst is used, the amount of the hydrolysis catalyst is ordinarily 0.0001 to 10 mol, preferably 0.001 to 1 mol per mol of the hydrolyzable group.

The reaction temperature for the hydrolysis and condensation is ordinarily equal to or higher than room temperature, and equal to or lower than the reflux temperature at normal pressure of an organic solvent usable for hydrolysis. The reaction temperature may be, for example, 20 to 110°C, or, for example, 20 to 80°C.

The hydrolysis may be performed completely; i.e. all hydrolyzable groups may be converted into silanol groups, or may be performed partially; i.e. unreacted hydrolyzable groups may remain.

Examples of the hydrolysis catalyst usable for the hydrolysis and condensation include a metal chelate compound, an organic acid, an inorganic acid, an organic base, and an inorganic base.

Examples of the metal chelate compound as the hydrolysis catalyst include, but are not limited to, titanium chelate compounds such as triethoxy-mono(acetylacetonate)titanium, tri-n-propoxy-mono(acetylacetonate)titanium, tri-i-propoxy-mono(acetylacetonate)titanium, tri-n-butoxy-mono(acetylacetonate)titanium, tri-sec-butoxy-mono(acetylacetonate)titanium, tri-t-butoxy-mono(acetylacetonate)titanium, diethoxy-bis(acetylacetonate)titanium, di-n-propoxy-bis(acetylacetonate)titanium, di-i-propoxy-bis(acetylacetonate)titanium, di-n-butoxy-bis(acetylacetonate)titanium, di-sec-butoxy-bis(acetylacetonate)titanium, di-t-butoxy-bis(acetylacetonate)titanium, monoethoxy-tris(acetylacetonate)titanium, mono-n-propoxy-tris(acetylacetonate)titanium, mono-i-propoxy-tris(acetylacetonate)titanium, mono-n-butoxy-tris(acetylacetonate)titanium, mono-sec-butoxy-tris(acetylacetonate)titanium, mono-t-butoxy-tris(acetylacetonate)titanium, tetrakis(acetylacetonate)titanium, triethoxy-mono(ethyl acetoacetate)titanium, tri-n-propoxy-mono(ethyl acetoacetate)titanium, tri-i-propoxy-mono(ethyl acetoacetate)titanium, tri-n-butoxy-mono(ethyl acetoacetate)titanium, tri-sec-butoxy-mono(ethyl acetoacetate)titanium, tri-t-butoxy-mono(ethyl acetoacetate)titanium, diethoxy-bis(ethyl acetoacetate)titanium, di-n-propoxy-bis(ethyl acetoacetate)titanium, di-i-propoxy-bis(ethyl acetoacetate)titanium, di-n-butoxy-bis(ethyl acetoacetate)titanium, di-sec-butoxy-bis(ethyl acetoacetate)titanium, di-t-butoxy-bis(ethyl acetoacetate)titanium, monoethoxy-tris(ethyl acetoacetate)titanium, mono-n-propoxy-tris(ethyl acetoacetate)titanium, mono-i-propoxy-tris(ethyl acetoacetate)titanium, mono-n-butoxy-tris(ethyl acetoacetate)titanium, mono-sec-butoxy-tris(ethyl acetoacetate)titanium, mono-t-butoxy-tris(ethyl acetoacetate)titanium, tetrakis(ethyl acetoacetate)titanium, mono(acetylacetonate)tris(ethyl acetoacetate)titanium, bis(acetylacetonate)bis(ethyl acetoacetate)titanium, and tris(acetylacetonate)mono(ethyl acetoacetate)titanium; zirconium chelate compounds such as triethoxy-mono(acetylacetonate) zirconium, tri-n-propoxy-mono(acetylacetonate) zirconium, tri-i-propoxy-mono(acetylacetonate) zirconium, tri-n-butoxy-mono(acetylacetonate) zirconium, tri-sec-butoxy-mono(acetylacetonate) zirconium, tri-t-butoxy-mono(acetylacetonate) zirconium, diethoxy-bis(acetylacetonate) zirconium, di-n-propoxy-bis(acetylacetonate) zirconium, di-i-propoxy-bis(acetylacetonate) zirconium, di-n-butoxy-bis(acetylacetonate) zirconium, di-sec-butoxy-bis(acetylacetonate) zirconium, di-t-butoxy-bis(acetylacetonate)zirconium, monoethoxy-tris(acetylacetonate) zirconium, mono-n-propoxy-tris(acetylacetonate) zirconium, mono-i-propoxy-tris(acetylacetonate) zirconium, mono-n-butoxy-tris(acetylacetonate) zirconium, mono-sec-butoxy-tris(acetylacetonate) zirconium, mono-t-butoxy-tris(acetylacetonate) zirconium, tetrakis(acetylacetonate)zirconium, triethoxy-mono(ethyl acetoacetate) zirconium, tri-n-propoxy-mono(ethyl acetoacetate) zirconium, tri-i-propoxy-mono(ethyl acetoacetate) zirconium, tri-n-butoxy-mono(ethyl acetoacetate) zirconium, tri-sec-butoxy-mono(ethyl acetoacetate) zirconium, tri-t-butoxy-mono(ethyl acetoacetate) zirconium, diethoxy-bis(ethyl acetoacetate) zirconium, di-n-propoxy-bis(ethyl acetoacetate) zirconium, di-i-propoxy-bis(ethyl acetoacetate) zirconium, di-n-butoxy-bis(ethyl acetoacetate) zirconium, di-sec-butoxy-bis(ethyl acetoacetate) zirconium, di-t-butoxy-bis(ethyl acetoacetate) zirconium, monoethoxy-tris(ethyl acetoacetate) zirconium, mono-n-propoxy-tris(ethyl acetoacetate) zirconium, mono-i-propoxy-tris(ethyl acetoacetate) zirconium, mono-n-butoxy-tris(ethyl acetoacetate) zirconium, mono-sec-butoxy-tris(ethyl acetoacetate) zirconium, mono-t-butoxy-tris(ethyl acetoacetate) zirconium, tetrakis(ethyl acetoacetate) zirconium, mono(acetylacetonate)tris(ethyl acetoacetate) zirconium, bis(acetylacetonate)bis(ethyl acetoacetate) zirconium, and tris(acetylacetonate)mono(ethyl acetoacetate) zirconium; and aluminum chelate compounds such as tris(acetylacetonate)aluminum and tris(ethyl acetoacetate)aluminum.

Examples of the organic acid as the hydrolysis catalyst include, but are not limited to, acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, and tartaric acid.

Examples of the inorganic acid as the hydrolysis catalyst include, but are not limited to, hydrochloric acid, nitric acid, sulfuric acid, hydrofluoric acid, and phosphoric acid.

Examples of the organic base as the hydrolysis catalyst include, but are not limited to, pyridine, pyrrole, piperazine, pyrrolidine, piperidine, picoline, trimethylamine, triethylamine, monoethanolamine, diethanolamine, dimethylmonoethanolamine, monomethyldiethanolamine, triethanolamine, diazabicyclooctane, diazabicyclononane, diazabicycloundecene, tetramethylammonium hydroxide, tetraethylammonium hydroxide, tetrapropylammonium hydroxide, tetrabutylammonium hydroxide, trimethylphenylammonium hydroxide, benzyltrimethylammonium hydroxide, and benzyltriethylammonium hydroxide.

Examples of the inorganic base as the hydrolysis catalyst include, but are not limited to, ammonia, sodium hydroxide, potassium hydroxide, barium hydroxide, and calcium hydroxide.

Among these catalysts, a metal chelate compound, an organic acid, and an inorganic acid are preferred. These catalysts may be used singly or in combination of two or more kinds thereof.

In particular, nitric acid can be preferably used as a hydrolysis catalyst in the present invention. By using a nitric acid, the storage stability of the reaction solution after hydrolysis and condensation can be improved, and in particular, a change in the molecular weight of the hydrolysis condensate or its modified product can be suppressed. The stability of the hydrolysis condensate or its modified product in the solution has been found to depend on the pH of the solution. As a result of intensive studies, it has been found that the pH of the reaction solution falls in a stable range by use of an appropriate amount of nitric acid.

As described above, nitric acid can also be used for preparation of a modified product of the hydrolysis condensate; for example, for capping of silanol groups with an alcohol. Thus, nitric acid is preferred from the viewpoint that it can contribute to the reactions of hydrolysis and condensation of the hydrolyzable silane, as well as the reaction of capping of the hydrolysis condensate with an alcohol.

When hydrolysis and condensation are performed, an organic solvent may be used as a solvent, and specific examples thereof include aliphatic hydrocarbon-based solvents such as n-pentane, i-pentane, n-hexane, i-hexane, n-heptane, i-heptane, 2,2,4-trimethylpentane, n-octane, i-octane, cyclohexane, and methylcyclohexane; aromatic hydrocarbon-based solvents such as benzene, toluene, xylene, ethylbenzene, trimethylbenzene, methylethylbenzene, n-propylbenzene, i-propylbenzene, diethylbenzene, i-butylbenzene, triethylbenzene, di-i-propylbenzene, and n-amylnaphthalene; monoalcohol-based solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, n-heptanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; polyhydric alcohol-based solvents such as ethylene glycol, propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin; ketone-based solvents such as acetone, methyl ethyl ketone, methyl-n-propyl ketone, methyl-n-butyl ketone, diethyl ketone, methyl-i-butyl ketone, methyl-n-pentyl ketone, ethyl-n-butyl ketone, methyl-n-hexyl ketone, di-i-butyl ketone, trimethylnonanone, cyclohexanone, methylcyclohexanone, 2,4-pentanedione, acetonylacetone, diacetone alcohol, acetophenone, and fenchon; ether-based solvents such as ethyl ether, i-propyl ether, n-butyl ether, n-hexyl ether, 2-ethylhexyl ether, ethylene oxide, 1,2-propylene oxide, dioxolane, 4-methyldioxolane, dioxane, dimethyldioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol monophenyl ether, ethylene glycol mono-2-ethyl butyl ether, ethylene glycol dibutyl ether, diethylene glycol monomethyl ether, diethylene glycol monoethyl ether, diethylene glycol diethyl ether, diethylene glycol mono-n-butyl ether, diethylene glycol din-butyl ether, diethylene glycol mono-n-hexyl ether, ethoxy triglycol, tetraethylene glycol di-n-butyl ether, propylene glycol monomethyl ether (1-methoxy-2-propanol), propylene glycol monoethyl ether (1-ethoxy-2-propanol), propylene glycol monopropyl ether, propylene glycol monobutyl ether, propylene glycol monomethyl ether acetate (1-methoxy-2-propanol monoacetate), dipropylene glycol monomethyl ether, dipropylene glycol monoethyl ether, dipropylene glycol monopropyl ether, dipropylene glycol monobutyl ether, tripropylene glycol monomethyl ether, tetrahydrofuran, and 2-methyltetrahydrofuran; ester-based solvents such as diethyl carbonate, methyl acetate, ethyl acetate, γ-butyrolactone, γ-valerolactone, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxytriglycol acetate, ethylene glycol diacetate, triethylene glycol methyl ether acetate, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate, and diethyl phthalate; nitrogen-containing solvents such as N-methylformamide, N,N-dimethylformamide, N,N-diethylformamide, acetamide, N-methylacetamide, N,N-dimethylacetamide, N-methylpropionamide, and N-methyl-2-pyrrolidone; and sulfur-containing solvents such as dimethyl sulfide, diethyl sulfide, thiophene, tetrahydrothiophene, dimethyl sulfoxide, sulfolane, and 1,3-propane sultone, but are not limited thereto. These solvents can be used singly or in combination of two or more kinds thereof.

After completion of the hydrolysis and condensation reactions, the reaction solution is used as it is, or diluted or concentrated. The resultant reaction solution can be neutralized and treated with an ion exchange resin, and thus the hydrolysis catalyst, e.g. an acid or a base, used for the hydrolysis and condensation can be removed. In addition, before or after such treatment, alcohol and water as by-products, the hydrolysis catalyst used, and the like can be removed from the reaction solution by distillation under reduced pressure or the like.

The thus-prepared hydrolysis condensate or a modified product of the hydrolysis condensate (hereinafter, also referred to as "polysiloxane") is in the form of a polysiloxane varnish dissolved in an organic solvent, which may be used as it is for preparation of the silicon-containing underlayer film-forming composition. That is, the reaction solution can be used as it is (or after dilution) for the preparation of the silicon-containing underlayer film-forming composition, and at this time, the hydrolysis catalyst used for hydrolysis and condensation, by-products, and the like may remain in the reaction solution as long as the effect of the present invention is not impaired. For example, nitric acid used as a hydrolysis catalyst or used for capping of silanol groups with an alcohol may remain in the polymer varnish solution in an amount of about 100 ppm to 5,000 ppm.

The resultant polysiloxane varnish may be subjected to solvent replacement, or may be appropriately diluted with a solvent. In a case where the storage stability of the resultant polysiloxane varnish is not poor, the organic solvent may be distilled off to achieve a film-forming component concentration of 100%. The film-forming component refers to a component resulted from the removal of a solvent component from all the components of the composition.

The organic solvent used for solvent replacement, dilution, or the like of the polysiloxane varnish may be identical to or different from the organic solvent used for the hydrolysis and condensation reactions of the hydrolyzable silane. The solvent for dilution is not particularly limited, and one kind or two or more kinds of solvents may be arbitrarily selected and used.

The polysiloxane may have a weight-average molecular weight of, for example, 500 to 1 million. From the viewpoint of preventing the precipitation of the polysiloxane in the composition, the weight-average molecular weight is preferably 500,000 or less, more preferably 250,000 or less, and still more preferably 100,000 or less. From the viewpoint of the compatibility between storage stability and coatability, the weight-average molecular weight may be preferably 700 or more, more preferably 1,000 or more.

Note that the weight-average molecular weight is a molecular weight obtained in terms of polystyrene by GPC analysis. The GPC analysis can be performed using, for example, a GPC apparatus (trade name: HLC-8220GPC, manufactured by Tosoh Corporation), a GPC column (trade name: Shodex (registered trademark) KF803L, KF802, KF801, manufactured by Showa Denko K.K.), at a column temperature of 40°C, with tetrahydrofuran as an eluent (elution solvent), at a flow amount (flow rate) of 1.0 mL/min, with polystyrene (Shodex (registered trademark) manufactured by Showa Denko K.K.) as a standard sample.

### <Component [B]: water>

In the first embodiment, the silicon-containing underlayer film-forming composition contains water.

In the second embodiment, the silicon-containing underlayer film-forming composition may contain water or may not contain water.

As the water, pure water, ultrapure water, ion exchange water, or the like can be used.

The content of water in the silicon-containing underlayer film-forming composition can be, for example, 30 mass% or less, preferably 20 mass% or less, and still more preferably 15 mass% or less relative to the total mass of the solvent contained in the composition.

### <Component [C]: curing catalyst>

In the first embodiment, the silicon-containing underlayer film-forming composition does not contain a curing catalyst.

In the second embodiment, the silicon-containing underlayer film-forming composition may contain a curing catalyst or may not contain a curing catalyst.

Herein, "not containing a curing catalyst" in the present invention means that a curing catalyst is not added to the silicon-containing underlayer film-forming composition, but a case where a curing catalyst is not detected when the silicon-containing underlayer film-forming composition is subjected to composition analysis (for example, mass spectrometry, IR analysis, gas chromatography analysis, and the like) also corresponds to "not containing a curing catalyst" in the present invention.

The curing catalyst may be, for example, an ammonium salt, a phosphine compound, a phosphonium salt, or a sulfonium salt. The following salts described as an example of the curing catalyst may be added in the form of a salt or may form a salt in the composition (one that is added as a separate compound at the time of addition and forms a salt in the system).

Examples of the ammonium salt include: a quaternary ammonium salt having a structure represented by the following formula (D-1): 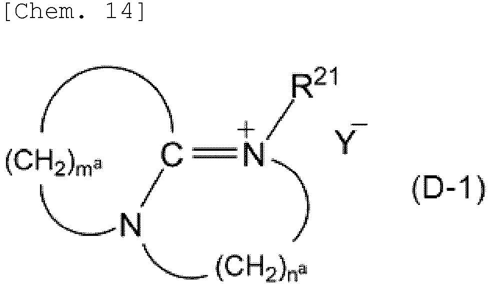
in the formula, m^{a} represents an integer of 2 to 11, n^{a} represents an integer of 2 to 3, R²¹ represents an alkyl group, an aryl group, or an aralkyl group, and Y⁻ represents an anion;
a quaternary ammonium salt having a structure represented by the following formula (D-2):
   [Chem. 15]

   R²²R²³R²⁴R²⁵N⁺Y⁻ (D-2)
in the formula, R²², R²³, R²⁴, and R²⁵ each independently represent an alkyl group, an aryl group, or an aralkyl group, Y⁻ represents an anion, and R²², R²³, R²⁴, and R²⁵ are each bonded to a nitrogen atom;
a quaternary ammonium salt having a structure represented by the following formula (D-3): 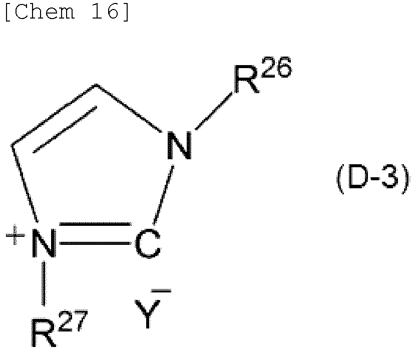
in the formula, R²⁶ and R²⁷ each independently represent an alkyl group, an aryl group, or an aralkyl group, and Y⁻ represents an anion;
a quaternary ammonium salt having a structure represented by the following formula (D-4): 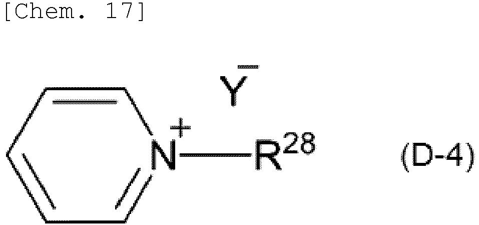
in the formula, R²⁸ represents an alkyl group, an aryl group, or an aralkyl group, and Y⁻ represents an anion;
a quaternary ammonium salt having a structure represented by the following formula (D-5): 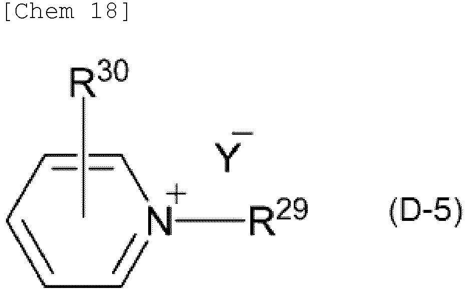
in the formula, R²⁹ and R³⁰ each independently represent an alkyl group, an aryl group, or an aralkyl group, and Y⁻ represents an anion; and
a tertiary ammonium salt having a structure represented by the following formula (D-6): 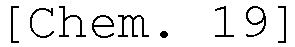 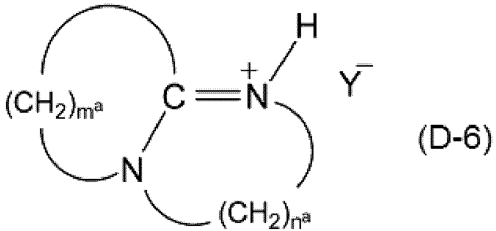
in the formula, m^{a} represents an integer of 2 to 11, n^{a} represents an integer of 2 to 3, and Y⁻ represents an anion.

Examples of the phosphonium salt include a quaternary phosphonium salt represented by the following formula (D-7):
[Chem. 20]

R³¹R³²R³³R³⁴P⁺Y⁻ (D-7)

in the formula, R³¹, R³², R³³, and R³⁴ each independently represent an alkyl group, an aryl group, or an aralkyl group, Y⁻ represents an anion, and each of R³¹, R³², R³³, and R³⁴ is bonded to the phosphorus atom.

Examples of the sulfonium salt include a tertiary sulfonium salt represented by the following formula (D-8): [Chem. 21]

R³⁵R³⁶R³⁷S⁺Y⁻ (D-8)

in the formula, R³⁵, R³⁶, and R³⁷ each independently represent an alkyl group, an aryl group, or an aralkyl group, Y⁻ represents an anion, and each of R³⁵, R³⁶, and R³⁷ is bonded to the sulfur atom.

The compound of the formula (D-1) is a quaternary ammonium salt derived from an amine, where m^{a} represents an integer of 2 to 11, and n^{a} represents an integer of 2 to 3. R²¹ of the quaternary ammonium salt represents, for example, an alkyl group having 1 to 18 carbon atoms, preferably 2 to 10 carbon atoms, an aryl group having 6 to 18 carbon atoms, or an aralkyl group having 7 to 18 carbon atoms. Examples thereof include linear alkyl groups such as an ethyl group, a propyl group, and a butyl group; a benzyl group, a cyclohexyl group, a cyclohexylmethyl group, and a dicyclopentadienyl group. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻).

The compound of the formula (D-2) is a quaternary ammonium salt represented by R²²R²³R²⁴R²⁵N⁺Y⁻. R²², R²³, R²⁴, and R²⁵ of this quaternary ammonium salt are each, for example, an alkyl group having 1 to 18 carbon atoms such as an ethyl group, a propyl group, a butyl group, a cyclohexyl group, and a cyclohexylmethyl group, an aryl group having 6 to 18 carbon atoms such as a phenyl group, or an aralkyl group having 7 to 18 carbon atoms such as a benzyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). The quaternary ammonium salt is commercially available, and examples of the quaternary ammonium salt include tetramethylammonium acetate, tetrabutylammonium acetate, triethylbenzylammonium chloride, triethylbenzylammonium bromide, trioctylmethylammonium chloride, tributylbenzylammonium chloride, and trimethylbenzylammonium chloride.

The compound of the formula (D-3) is a quaternary ammonium salt derived from 1-substituted imidazole. The number of carbon atoms of each of R²⁶ and R²⁷ is, for example, 1 to 18, and the total number of carbon atoms of R²⁶ and R²⁷ is preferably 7 or more. Examples of R²⁶ include alkyl groups, such as a methyl group, an ethyl group, and a propyl group, aryl groups, such as a phenyl group, and aralkyl groups, such as a benzyl group. Examples of R²⁷ include aralkyl groups, such as a benzyl group, and alkyl groups, such as an octyl group and an octadecyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between an imidazole compound (e.g. 1-methylimidazole or 1-benzylimidazole) and an aralkyl halide, an alkyl halide, or an aryl halide, such as benzyl bromide, methyl bromide, or benzene bromide.

The compound of the formula (D-4) is a quaternary ammonium salt derived from pyridine. R²⁸ is, for example, an alkyl group having 1 to 18 carbon atoms, preferably 4 to 18 carbon atoms, an aryl group having 6 to 18 carbon atoms, or an aralkyl group having 7 to 18 carbon atoms. Examples thereof include a butyl group, an octyl group, a benzyl group, and a lauryl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between pyridine and an alkyl halide or an aryl halide, such as lauryl chloride, benzyl chloride, benzyl bromide, methyl bromide, or octyl bromide. Examples of this compound include N-laurylpyridinium chloride and N-benzylpyridinium bromide.

The compound of the formula (D-5) is a quaternary ammonium salt derived from a substituted pyridine, such as picoline. R²⁹ is, for example, an alkyl group having 1 to 18 carbon atoms, preferably 4 to 18 carbon atoms, an aryl group having 6 to 18 carbon atoms, or an aralkyl group having 7 to 18 carbon atoms. Examples thereof include a methyl group, an octyl group, a lauryl group, and a benzyl group. R³⁰ is, for example, an alkyl group having 1 to 18 carbon atoms, an aryl group having 6 to 18 carbon atoms, or an aralkyl group having 7 to 18 carbon atoms. For example, R³⁰ is a methyl group when the compound represented by the formula (D-5) is a quaternary ammonium derived from picoline. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between a substituted pyridine (e.g. picoline) and an alkyl halide or an aryl halide, such as methyl bromide, octyl bromide, lauryl chloride, benzyl chloride, or benzyl bromide. Examples of this compound include N-benzylpicolinium chloride, N-benzylpicolinium bromide, and N-laurylpicolinium chloride.

The compound of the formula (D-6) is a tertiary ammonium salt derived from an amine, where m^{a} represents an integer of 2 to 11, and n^{a} represents 2 or 3. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). The compound may be produced through reaction between an amine and a weak acid, such as a carboxylic acid or phenol. Examples of the carboxylic acid include formic acid and acetic acid. When formic acid is used, the anion (Y⁻) is (HCOO⁻). When acetic acid is used, the anion (Y⁻) is (CH₃COO⁻). When phenol is used, the anion (Y⁻) is (C₆H₅O⁻).

The compound of the formula (D-7) is a quaternary phosphonium salt having a structure of R³¹R³²R³³R³⁴P⁺Y⁻. R³¹, R³², R³³, and R³⁴ are each, for example, an alkyl group having 1 to 18 carbon atoms, such as an ethyl group, a propyl group, a butyl group, or cyclohexylmethyl, an aryl group having 6 to 18 carbon atoms, such as a phenyl group, or an aralkyl group having 7 to 18 carbon atoms, such as a benzyl group. Three of four substituents of R³¹ to R³⁴ are each preferably an unsubstituted phenyl group or a substituted phenyl group. Examples thereof include a phenyl group or a tolyl group. The remaining one substituent is an alkyl group having 1 to 18 carbon atoms, an aryl group having 6 to 18 carbon atoms, or an aralkyl group having 7 to 18 carbon atoms. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). This compound is commercially available, and examples of the compound include tetraalkylphosphonium halides, such as tetra-n-butylphosphonium halide and tetra-n-propylphosphonium halide; trialkylbenzylphosphonium halides, such as triethylbenzylphosphonium halide; triphenylmonoalkylphosphonium halides, such as triphenylmethylphosphonium halide and triphenylethylphosphonium halide; triphenylbenzylphosphonium halide; tetraphenylphosphonium halide; tritolylmonoarylphosphonium halide; or tritolylmonoalkylphosphonium halide, where the halogen atom is a chlorine atom or a bromine atom. Particularly preferred are triphenylmonoalkylphosphonium halides, such as triphenylmethylphosphonium halide and triphenylethylphosphonium halide; triphenylmonoarylphosphonium halides, such as triphenylbenzylphosphonium halide; tritolylmonoarylphosphonium halides, such as tritolylmonophenylphosphonium halide; and tritolylmonoalkylphosphonium halides, such as tritolylmonomethylphosphonium halide, where the halogen atom is a chlorine atom or a bromine atom.

Examples of the phosphine compound include primary phosphines, such as methylphosphine, ethylphosphine, propylphosphine, isopropylphosphine, isobutylphosphine, and phenylphosphine; secondary phosphines, such as dimethylphosphine, diethylphosphine, diisopropylphosphine, diisoamylphosphine, and diphenylphosphine; and tertiary phosphines, such as trimethylphosphine, triethylphosphine, triphenylphosphine, methyldiphenylphosphine, and dimethylphenylphosphine.

The compound of the formula (D-8) is a tertiary sulfonium salt having a structure of R³⁵R³⁶R³⁷S⁺Y⁻. R³⁵, R³⁶, and R³⁷ are each, for example, an alkyl group having 1 to 18 carbon atoms, such as an ethyl group, a propyl group, a butyl group, or a cyclohexylmethyl, an aryl group having 6 to 18 carbon atoms, such as a phenyl group, or an aralkyl group having 7 to 18 carbon atoms, such as a benzyl group. Two of three substituents of R³⁵ to R³⁷ are each preferably an unsubstituted phenyl group or a substituted phenyl group. Examples thereof include a phenyl group or a tolyl group. The remaining one substituent is an alkyl group having 1 to 18 carbon atoms, an aryl group having 6 to 18 carbon atoms, or an aralkyl group having 7 to 18 carbon atoms. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), alcoholate (-O⁻), maleate anion, and nitrate anion. This compound is commercially available, and examples of the compound include trialkylsulfonium halides, such as tri-n-butylsulfonium halide and tri-n-propylsulfonium halide; dialkylbenzylsulfonium halides, such as diethylbenzylsulfonium halide; diphenylmonoalkylsulfonium halides, such as diphenylmethylsulfonium halide and diphenylethylsulfonium halide; triphenylsulfonium halides, where the halogen atom is a chlorine atom or a bromine atom; trialkylsulfonium carboxylates, such as tri-n-butylsulfonium carboxylate and tri-n-propylsulfonium carboxylate; dialkylbenzylsulfonium carboxylates, such as diethylbenzylsulfonium carboxylate; diphenylmonoalkylsulfonium carboxylates, such as diphenylmethylsulfonium carboxylate and diphenylethylsulfonium carboxylate; and triphenylsulfonium carboxylate. Further, triphenylsulfonium halide and triphenylsulfonium carboxylate are preferably used.

The content of the curing catalyst [C] in the silicon-containing underlayer film-forming composition as the second embodiment is not particularly limited, and may be, for example, 0.1 to 30 parts by mass, 0.5 to 25 parts by mass, or 1 to 20 parts by mass relative to 100 parts by mass of the polysiloxane [A].

### <Component [D]: organic solvent>

The silicon-containing underlayer film-forming composition may contain an organic solvent.

The organic solvent [D] is preferably an alcohol-based solvent, more preferably alkylene glycol monoalkyl ether: alcohol-based solvent, and still more preferably propylene glycol monoalkyl ether. These organic solvents are also capping agents for silanol groups of the hydrolysis condensate, and thus the solvent replacement or the like is not required. The silicon-containing underlayer film-forming composition can be prepared from a solution obtained by preparation of the polysiloxane [A].

Examples of the alkylene glycol monoalkyl ether include ethylene glycol monomethyl ether, ethylene glycol monoethyl ether, ethylene glycol monopropyl ether, ethylene glycol monobutyl ether, propylene glycol monomethyl ether (1-methoxy-2-propanol), propylene glycol monoethyl ether (1-ethoxy-2-propanol), methyl isobutyl carbinol, and propylene glycol monobutyl ether.

Specific examples of other organic solvents [D] include methyl cellosolve acetate, ethyl cellosolve acetate, propylene glycol, propylene glycol monomethyl ether acetate (1-methoxy-2-propanol monoacetate), propylene glycol monoethyl ether acetate, propylene glycol monopropyl ether acetate, propylene glycol monobutyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethylene glycol monomethyl ether acetate, ethylene glycol monoethyl ether acetate, ethylene glycol monopropyl ether acetate, ethylene glycol monobutyl ether acetate, diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, propylene glycol dibutyl ether, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, ethyl 2-hydroxy-2-methylpropionate, methyl 3-methoxy-2-methylpropionate, methyl 2-hydroxy-3-methylbutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, toluene, xylene, methyl ethyl ketone, methyl propyl ketone, methyl butyl ketone, 2-heptanone, 3-heptanone, 4-heptanone, cyclohexanone, N,N-dimethylformamide, N-methylacetamide, N,N-dimethylacetamide, N-methyl-2-pyrrolidone, 4-methyl-2-pentanol, and γ-butyrolactone. These solvents can be used singly or in combination of two or more kinds thereof.

### <Component [E]: nitric acid>

The silicon-containing underlayer film-forming composition preferably contains nitric acid [E].

Nitric acid [E] may be added during preparation of the silicon-containing underlayer film-forming composition. However, nitric acid may be used as a hydrolysis catalyst or used for capping of silanol groups with an alcohol in the production of the polysiloxane described above, and nitric acid remaining in the resultant polysiloxane varnish may be used as nitric acid [E]

The amount of the nitric acid [E] (amount of residual nitric acid) added may be, for example, 0.0001 mass% to 1 mass%, 0.001 mass% to 0.1 mass%, or 0.005 mass% to 0.05 mass% relative to the total mass of the silicon-containing underlayer film-forming composition.

### <Other additives>

In the silicon-containing underlayer film-forming composition, various additives can be blended depending on the use of the composition.

Examples of the additives include known additives incorporated in materials (compositions) for forming various films (e.g. resist underlayer film, anti-reflective coating, and pattern reversing film) that can be used in the production of a semiconductor device, such as a crosslinking agent, a stabilizer (e.g. an organic acid, water, or an alcohol), an organic polymer, an acid generator, a surfactant (e.g. a nonionic surfactant, an anionic surfactant, a cationic surfactant, a silicon-based surfactant, a fluorine-based surfactant, or an UV-curable surfactant), a pH adjuster, a metal oxide, a rheology controlling agent, and an adhesion aid.

Hereinafter, various additives will be exemplified, but the additives are not limited thereto.

### <<Stabilizer>>

The stabilizer may be added for the purpose of stabilizing the hydrolysis condensate of the hydrolyzable silane, and as a specific example thereof, an organic acid, water, alcohol, or a combination thereof may be added.

Examples of the organic acid include an oxalic acid, a malonic acid, a methylmalonic acid, a succinic acid, a maleic acid, a malic acid, a tartaric acid, a phthalic acid, a citric acid, a glutaric acid, a lactic acid, and a salicylic acid. Among these, an oxalic acid and a maleic acid are preferable. When the organic acid is added, the amount of the organic acid added is 0.1 to 5.0 mass% relative to the mass of the hydrolysis condensate of the hydrolyzable silane. These organic acids may also serve as pH adjusters.

The alcohol is preferably an alcohol that is easily volatilized by heating after coating, and examples of the alcohol include methanol, ethanol, propanol, i-propanol, and butanol. When an alcohol is added, the amount of the alcohol added may be 1 to 20 parts by mass relative to 100 parts by mass of the silicon-containing underlayer film-forming composition.

### <<Organic polymer>>

Addition of the organic polymer to the silicon-containing underlayer film-forming composition enables adjustment of the dry etching rate (the amount of reduction in film thickness per unit time), attenuation coefficient, refractive index, and the like of a film formed from the composition. The organic polymer is not particularly limited, and is appropriately selected from various organic polymers (polycondensation polymer and addition polymerization polymer) depending on the purpose of addition thereof.

Specific examples of the organic polymer include addition polymerization polymers and polycondensation polymers, such as polyester, polystyrene, polyimide, acrylic polymer, methacrylic polymer, polyvinyl ether, phenol novolac, naphthol novolac, polyether, polyamide, and polycarbonate.

In the present invention, an organic polymer containing an aromatic ring or a heteroaromatic ring such as a benzene ring, a naphthalene ring, an anthracene ring, a triazine ring, a quinoline ring, or a quinoxaline ring, which functions as a light-absorbing moiety, can also be preferably used when such a function is required. Specific examples of such an organic polymer include, but are not limited to, addition polymerization polymers containing, as structural units, addition polymerizable monomers, such as benzyl acrylate, benzyl methacrylate, phenyl acrylate, naphthyl acrylate, anthryl methacrylate, anthrylmethyl methacrylate, styrene, hydroxystyrene, benzyl vinyl ether, and N-phenylmaleimide, and polycondensation polymers, such as phenol novolac and naphthol novolac.

When an addition polymerization polymer is used as an organic polymer, the polymer may be either a homopolymer or a copolymer.

An addition polymerizable monomer is used for the production of the addition polymerization polymer. Specific examples of the addition polymerizable monomer include, but are not limited to, acrylic acid, methacrylic acid, an acrylate ester compound, a methacrylate ester compound, an acrylamide compound, a methacrylamide compound, a vinyl compound, a styrene compound, a maleimide compound, maleic anhydride, and acrylonitrile.

Specific examples of the acrylate ester compound include, but are not limited to, methyl acrylate, ethyl acrylate, normal hexyl acrylate, i-propyl acrylate, cyclohexyl acrylate, benzyl acrylate, phenyl acrylate, anthrylmethyl acrylate, 2-hydroxyethyl acrylate, 3-chloro-2-hydroxypropyl acrylate, 2-hydroxypropyl acrylate, 2,2,2-trifluoroethyl acrylate, 2,2,2-trichloroethyl acrylate, 2-bromoethyl acrylate, 4-hydroxybutyl acrylate, 2-methoxyethyl acrylate, tetrahydrofurfuryl acrylate, 2-methyl-2-adamantyl acrylate, 5-acryloyloxy-6-hydroxynorbornene-2-carboxylic-6-lactone, 3-acryloxypropyltriethoxysilane, and glycidyl acrylate.

Specific examples of the methacrylate ester compound include, but are not limited to, methyl methacrylate, ethyl methacrylate, normal hexyl methacrylate, i-propyl methacrylate, cyclohexyl methacrylate, benzyl methacrylate, phenyl methacrylate, anthrylmethyl methacrylate, 2-hydroxyethyl methacrylate, 2-hydroxypropyl methacrylate, 2,2,2-trifluoroethyl methacrylate, 2,2,2-trichloroethyl methacrylate, 2-bromoethyl methacrylate, 4-hydroxybutyl methacrylate, 2-methoxyethyl methacrylate, tetrahydrofurfuryl methacrylate, 2-methyl-2-adamantyl methacrylate, 5-methacryloyloxy-6-hydroxynorbornene-2-carboxylic-6-lactone, 3-methacryloxypropyltriethoxysilane, glycidyl methacrylate, 2-phenylethyl methacrylate, hydroxyphenyl methacrylate, and bromophenyl methacrylate.

Specific examples of the acrylamide compound include, but are not limited to, acrylamide, N-methylacrylamide, N-ethylacrylamide, N-benzylacrylamide, N-phenylacrylamide, N,N-dimethylacrylamide, and N-anthrylacrylamide.

Specific examples of the methacrylamide compound include, but are not limited to, methacrylamide, N-methylmethacrylamide, N-ethylmethacrylamide, N-benzylmethacrylamide, N-phenylmethacrylamide, N,N-dimethylmethacrylamide, and N-anthrylmethacrylamide.

Specific examples of the vinyl compound include, but are not limited to, vinyl alcohol, 2-hydroxyethyl vinyl ether, methyl vinyl ether, ethyl vinyl ether, benzyl vinyl ether, vinyl acetate, vinyltrimethoxysilane, 2-chloroethyl vinyl ether, 2-methoxyethyl vinyl ether, vinylnaphthalene, and vinylanthracene.

Specific examples of the styrene compound include, but are not limited to, styrene, hydroxystyrene, chlorostyrene, bromostyrene, methoxystyrene, cyanostyrene, and acetylstyrene.

Examples of the maleimide compound include, but are not limited to, maleimide, N-methylmaleimide, N-phenylmaleimide, N-cyclohexylmaleimide, N-benzylmaleimide, and N-hydroxyethylmaleimide.

When a polycondensation polymer is used as the organic polymer, the polymer is, for example, a polycondensation polymer composed of a glycol compound and a dicarboxylic acid compound. Examples of the glycol compound include diethylene glycol, hexamethylene glycol, and butylene glycol. Examples of the dicarboxylic acid compound include succinic acid, adipic acid, terephthalic acid, and maleic anhydride. Further, examples of the polymer include, but are not limited to, polyesters, polyamides, and polyimides, such as polypyromellitimide, poly(p-phenyleneterephthalamide), polybutylene terephthalate, and polyethylene terephthalate.

When the organic polymer contains a hydroxy group, the hydroxy group may be crosslinked with a hydrolysis condensate, or the like.

The organic polymer may ordinarily have a weight-average molecular weight of 1,000 to 1,000,000. From the viewpoint of sufficiently achieving the effect of the polymer function and preventing the precipitation of the polymer in the composition, the weight-average molecular weight of the organic polymer to be added may be, for example, 3,000 to 300,000, 5,000 to 300,000, or 10,000 to 200,000.

Such an organic polymer may be used singly or in combination of two or more kinds thereof.

When the silicon-containing underlayer film-forming composition contains an organic polymer, the content of the organic polymer cannot be univocally determined, since the content should be appropriately determined in consideration of the function of the organic polymer or the like. Ordinarily, the content may be 1 to 200 mass% relative to the mass of the polysiloxane [A]. From the viewpoint of preventing the precipitation of the organic polymer in the composition and the like, the content may be, for example, 100 mass% or less, preferably 50 mass% or less, and more preferably 30 mass% or less. From the viewpoint of sufficiently achieving the effect of the polymer and the like, the content may be, for example, 5 mass% or more, preferably 10 mass% or more, more preferably 30 mass% or more.

### <<Acid generator>>

Examples of the acid generator include a thermal acid generator and a photoacid generator, and a photoacid generator may be preferably used.

Examples of the photoacid generator include, but are not limited to, an onium salt compound, a sulfonimide compound, and a disulfonyldiazomethane compound. The photoacid generator may also function as a curing catalyst depending on the type thereof, for example, a nitrate salt, a carboxylate salt (e.g. maleate), or a hydrochloride salt of an onium salt compound described below.

Examples of the thermal acid generator include, but are not limited to, tetramethylammonium nitrate.

Specific examples of the onium salt compound include, but are not limited to, iodonium salt compounds, such as diphenyliodonium hexafluorophosphate, diphenyliodonium trifluoromethanesulfonate, diphenyliodonium nonafluoro normal butanesulfonate, diphenyliodonium perfluoro normal octanesulfonate, diphenyliodonium camphorsulfonate, bis(4-t-butylphenyl)iodonium camphorsulfonate, and bis(4-t-butylphenyl)iodonium trifluoromethanesulfonate; and sulfonium salt compounds, such as triphenylsulfonium hexafluoroantimonate, triphenylsulfonium nonafluoro normal butanesulfonate, triphenylsulfonium camphorsulfonate, triphenylsulfonium trifluoromethanesulfonate, triphenylsulfonium nitrate, triphenylsulfonium trifluoroacetate, triphenylsulfonium maleate, and triphenylsulfonium chloride.

Specific examples of the sulfonimide compound include, but are not limited to, N-(trifluoromethanesulfonyloxy)succinimide, N-(nonafluoro normal butane sulfonyloxy)succinimide, N-(camphorsulfonyloxy)succinimide, and N-(trifluoromethanesulfonyloxy)naphthalimide.

Specific examples of the disulfonyldiazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyldiazomethane.

When the silicon-containing underlayer film-forming composition contains an acid generator, the content of the acid generator cannot be univocally determined, since the amount should be appropriately determined in consideration of the type of the acid generator and the like. Ordinarily, the content of the acid generator is 0.01 to 5 mass% relative to the mass of the polysiloxane [A]. From the viewpoint of preventing the precipitation of the acid generator in the composition and the like, the content is preferably 3 mass% or less, more preferably 1 mass% or less. From the viewpoint of sufficiently achieving the effect of the acid generator and the like, the content is preferably 0.1 mass% or more, more preferably 0.5 mass% or more.

The acid generators may be used singly or in combination of two or more kinds thereof. A photoacid generator and a thermal acid generator may be used in combination.

### <<Surfactant>>

When the silicon-containing underlayer film-forming composition is applied to a substrate, a surfactant is effective in suppressing occurrence of pinholes, striations, and the like. Examples of the surfactant include a nonionic surfactant, an anionic surfactant, a cationic surfactant, a silicon-based surfactant, a fluorine-based surfactant, and a UV-curable surfactant. Specific examples of the surfactant include, but are not limited to, nonionic surfactants, for example, polyoxyethylene alkyl ethers, such as polyoxyethylene lauryl ether, polyoxyethylene stearyl ether, polyoxyethylene cetyl ether, and polyoxyethylene oleyl ether, polyoxyethylene alkylaryl ethers, such as polyoxyethylene octylphenol ether and polyoxyethylene nonylphenol ether, polyoxyethylene-polyoxypropylene block copolymers, sorbitan fatty acid esters, such as sorbitan monolaurate, sorbitan monopalmitate, sorbitan monostearate, sorbitan monooleate, sorbitan trioleate, and sorbitan tristearate, polyoxyethylene sorbitan fatty acid esters, such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants, such as trade names EFTOP (registered trademark) EF301, EF303, and EF352 (manufactured by Mitsubishi Materials Electronic Chemicals Co., Ltd. (former Tohkem Products Corporation)), trade names MEGAFACE (registered trademark) F171, F173, R-08, R-30, R-30N, and R-40LM (manufactured by DIC Corporation), Fluorad FC430 and FC431 (manufactured by 3M Japan Limited), trade name AsahiGuard (registered trademark) AG710 (manufactured by AGC Inc.), and trade names SURFLON (registered trademark) S-382, SC101, SC102, SC103, SC104, SC105, and SC106 (manufactured by AGC Seimi Chemical Co., Ltd.); and Organosiloxane Polymer KP341 (manufactured by Shin-Etsu Chemical Co., Ltd.).

The surfactants may be used singly or in combination of two or more kinds thereof.

When the silicon-containing underlayer film-forming composition contains a surfactant, the content of the surfactant is ordinarily 0.0001 to 5 mass%, preferably 0.001 to 4 mass%, and more preferably 0.01 to 3 mass% relative to the mass of the polysiloxane [A].

### <<Rheology controlling agent>>

The rheology controlling agent is added mainly for the purpose of improving the fluidity of the silicon-containing underlayer film-forming composition, particularly in a baking treatment, improving the uniformity of the film thickness of a film to be formed, or improving the fillability of the composition into holes. Specific examples of the rheology controlling agent include phthalic acid derivatives, such as dimethyl phthalate, diethyl phthalate, di-i-butyl phthalate, dihexyl phthalate, and butyl-i-decyl phthalate; adipic acid derivatives, such as di-normal butyl adipate, di-i-butyl adipate, di-i-octyl adipate, and octyl decyl adipate; maleic acid derivatives, such as di-normal butyl maleate, diethyl maleate, and dinonyl maleate; oleic acid derivatives, such as methyl oleate, butyl oleate, and tetrahydrofurfuryl oleate; and stearic acid derivatives, such as normal butyl stearate and glyceryl stearate.

When such a rheology controlling agent is used, the amount of the rheology controlling agent added is ordinarily less than 30 mass% relative to all film-forming components of the silicon-containing underlayer film-forming composition.

### <<Adhesion aid>>

The adhesion aid is added mainly for the purpose of improving adhesion with a substrate or an adjacent layer (for example, the surface modification layer). Specific examples of the adhesion aid include chlorosilanes, such as trimethylchlorosilane, dimethylvinylchlorosilane, methyldiphenylchlorosilane, and chloromethyldimethylchlorosilane; alkoxysilanes, such as trimethylmethoxysilane, dimethyldiethoxysilane, methyldimethoxysilane, and dimethylvinylethoxysilane; silazanes, such as hexamethyldisilazane, N,N'-bis(trimethylsilyl)urea, dimethyltrimethylsilylamine, and trimethylsilyl imidazole; other silanes, such as γ-chloropropyltrimethoxysilane, γ-aminopropyltriethoxysilane, and γ-glycidoxypropyltrimethoxysilane; heterocyclic compounds, such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, mercaptopyrimidine; and urea or thiourea compounds, such as 1,1-dimethylurea and 1,3-dimethylurea.

When such an adhesion aid is used, the amount of the adhesion aid added is ordinarily less than 5 mass%, preferably less than 2 mass%, relative to the film-forming components of the silicon-containing underlayer film-forming composition.

### <<pH adjuster>>

In addition, examples of the pH adjuster can include other acids having one or two or more carboxylic acid groups such as the organic acids described above as the stabilizer. When a pH adjuster is used, the amount of the pH adjuster added may be 0.01 to 20 parts by mass, 0.01 to 10 parts by mass, or 0.01 to 5 parts by mass relative to 100 parts by mass of the polysiloxane [A].

<<Metal oxide>>

Examples of the metal oxide that may be added to the silicon-containing underlayer film-forming composition include, but are not limited to, oxides of a combination of one or more selected from among metals, such as tin (Sn), titanium (Ti), aluminum (Al), zirconium (Zr), zinc (Zn), niobium (Nb), tantalum (Ta), and W (tungsten), and semimetals, such as boron (B), silicon (Si), germanium (Ge), arsenic (As), antimony (Sb), and tellurium (Te).

The concentration of the film-forming component in the silicon-containing underlayer film-forming composition may be, for example, 0.1 to 50 mass%, 0.1 to 30 mass%, 0.1 to 25 mass%, or 0.5 to 20.0 mass% relative to the total mass of the composition.

The content of the polysiloxane [A] in the film-forming component is ordinarily 20 mass% to 100 mass%. From the viewpoint of achieving the effects of the present invention at high reproducibility or the like, the lower limit of the content of the polysiloxane [A] is preferably 50 mass%, more preferably 60 mass%, still more preferably 70 mass%, and yet still more preferably 80 mass%. The upper limit of the content is preferably 99 mass%. The balance may be an additive described below.

Further, the silicon-containing underlayer film-forming composition preferably has a pH of 2 to 5, more preferably a pH of 3 to 4.

In the present invention, the silicon-containing underlayer film-forming composition may be filtered with a submicrometer-order filter or the like during production of the composition or after mixing of all the components. The type of the material of the filter used is not limited. For example, a nylon-made filter or a fluororesin-made filter may be used.

The silicon-containing underlayer film-forming composition of the present invention may be suitably used as an underlayer film-forming composition used in a lithography process.

The silicon-containing underlayer film-forming composition of the present invention is preferably used for EUV lithography.

### <Surface modification layer and surface modification layer-forming composition>

The silicon-containing underlayer film-forming composition of the present invention is a composition for forming a silicon-containing underlayer film on which a surface modification layer having a film thickness of 5 nm or less is formed.

The surface modification layer is formed using, for example, a surface modification layer-forming composition.

Hereinafter, the surface modification layer and the surface modification layer-forming composition will be described.

The surface modification layer is not particularly limited, but is preferably a silicon-containing layer.

The surface modification layer is preferably a layer containing polysiloxane. The polysiloxane in the surface modification layer may be crosslinked or may not be crosslinked.

### <<Surface modification layer-forming composition (S1)>>

The surface modification layer is preferably formed using a surface modification layer-forming composition containing polysiloxane and a solvent.

Hereinafter, the surface modification layer-forming composition containing a polysiloxane and a solvent may be referred to as a surface modification layer-forming composition (S1).

The polysiloxane contained in the surface modification layer-forming composition (S1) may include a modified polysiloxane in which some of silanol groups are modified, for example, a polysiloxane modified product in which some of silanol groups are alcohol-modified or acetal-protected.

Further, the polysiloxane may contain, as an example, a hydrolysis condensate of a hydrolyzable silane, and may contain a modified polysiloxane in which at least some of silanol groups of the hydrolysis condensate are alcohol-modified or acetal-protected. The hydrolyzable silane related to the hydrolysis condensate may include one type or two or more types of hydrolyzable silanes. The polysiloxane to be used may be a commercially available polysiloxane.

Hereinafter, the polysiloxane contained in the surface modification layer-forming composition (S1) may be referred to as "polysiloxane (S)".

The polysiloxane (S) preferably includes 50 mol% or more of T units, more preferably 65 mol% or more, and particularly preferably 80 mol% or more relative to all units.

The upper limit of the ratio of the T unit to all units in the polysiloxane (S) is not particularly limited, and the ratio of the T unit may be, for example, 100 mol% or less.

The polysiloxane (S) may include a Q unit or may not include a Q unit.

The ratio of the Q unit to all units in the polysiloxane (S) is not particularly limited, and may be, for example, 0 mol% to 50 mol%, 0 mol% to 35 mol%, or 0 mol% to 20 mol%.

The polysiloxane (S) preferably includes the total of the Q unit and the T unit in an amount of 70 mol% to 100 mol%, more preferably 80 mol% to 100 mol%, and particularly preferably 90 mol% to 100 mol% relative to all units.

The polysiloxane (S) is suitably a hydrolysis condensate of a hydrolyzable silane (Si-2).

The hydrolyzable silane (Si-2) preferably includes a hydrolyzable silane represented by the following formula (S1).
[Chem. 22]

**R²¹ₐSi(R²²)₄₋ₐ** **(S1)**

In the formula (S1), R²¹ represents a group bonded to a silicon atom, and each independently represents an organic group having a number of carbon atoms of 1 to 45,
R²² is a group or atom bonded to a silicon atom, and each independently represents an alkoxy group, an aralkyloxy group, an acyloxy group, or a halogen atom, and
a represents an integer of 1 to 3.

### <<<R²¹ in formula (S1)>>>

In the formula (S1), R²¹ represents a group bonded to a silicon atom, and each independently represents an organic group having 1 to 45 carbon atoms.

R²¹ is not a hydrolyzable group.

Examples of R²¹ include an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group, an optionally substituted alkoxyaralkyl group, an optionally substituted alkenyl group, an organic group having a cyclic urea skeleton, an organic group having an optionally ring-opened epoxy group, an organic group having an acryloyl group, an organic group having a methacryloyl group, an organic group having a mercapto group, an organic group having an amino group, an organic group having an alkoxy group, an organic group having a sulfonyl group, an organic group having a cyano group, or
combinations of two or more thereof.

Specific examples and preferable examples of R²¹ include the specific examples and preferable examples given in the description of R¹¹ in the formula (B).

### <<<R²² in formula (S1)>>>

R²² in the formula (S1) is a group or atom bonded to a silicon atom, and each independently represents an alkoxy group, an aralkyloxy group, an acyloxy group, or a halogen atom.

Specific examples and preferable examples of R²² in the formula (S1) include the specific examples and preferable examples given in the description of R in the formula (A).

The hydrolyzable silane (Si-1) may include a hydrolyzable silane represented by the following formula (S2).
[Chem. 23]

**SiR₄** **(S2)**

In the formula (S2), R represents a group or atom bonded to a silicon atom, and each independently represents an alkoxy group, an aralkyloxy group, an acyloxy group, or a halogen atom.

R in the formula (S2) is a group or atom bonded to a silicon atom, and each independently represents an alkoxy group, an aralkyloxy group, an acyloxy group, or a halogen atom.

Specific examples and preferable examples of R in the formula (S2) include the specific examples and preferable examples given in the description of R in the formula (A).

The ratio of the hydrolyzable silane represented by the formula (S1) in the hydrolyzable silane (Si-2) when the hydrolyzable silane (Si-2) is hydrolytically condensed to obtain a polysiloxane (S) is preferably 50 mol% or more, more preferably 65 mol% or more, and particularly preferably 80 mol% or more.

The upper limit value of the ratio of the hydrolyzable silane represented by the formula (S1) in the hydrolyzable silane (Si-2) when the hydrolyzable silane (Si-2) is hydrolytically condensed to obtain a polysiloxane is not particularly limited, and the ratio may be, for example, 100 mol% or less.

The ratio of the hydrolyzable silane represented by the formula (S2) in the hydrolyzable silane (Si-2) when the hydrolyzable silane (Si-2) is hydrolytically condensed to obtain the polysiloxane (S) is not particularly limited, and may be, for example, 0 mol% to 50 mol%, 0 mol% to 35 mol%, or 0 mol% to 20 mol%.

The ratio of total of the hydrolyzable silane represented by the formula (S1) and the hydrolyzable silane represented by the formula (S2) in the hydrolyzable silane (Si-2) when the hydrolyzable silane (Si-2) is hydrolytically condensed to obtain a polysiloxane is not particularly limited, but is preferably 70 mol% to 100 mol%, more preferably 80 mol% to 100 mol%, and particularly preferably 90 mol% to 100 mol%.

The polysiloxane (S) may be a hydrolysis condensate of a hydrolyzable silane (Si-2) containing a silane compound other than those exemplified above or a modified product as long as the effects of the present invention are not impaired.

As described above, as the polysiloxane (S), a modified product in which at least some of silanol groups of the hydrolysis condensate are modified can be used. For example, a modified product in which some of silanol groups are alcohol-modified or acetal-protected can be used.

Examples of the polysiloxane as the modified product include a reaction product obtained by a reaction between at least some of silanol groups and a hydroxy group of an alcohol in the hydrolysis condensate of the hydrolyzable silane described above, a dehydration reaction product between the condensate and an alcohol, and a modified product obtained by protecting at least some of silanol groups of the condensate with an acetal group.

Specific examples of the alcohol used for alcohol modification include the alcohols described in the description of alcohol modification of the polysiloxane as the component [A].

Specific examples of the vinyl ether used for the acetal protection include the vinyl ethers described in the description of the acetal protection of the polysiloxane as the component [A].

Examples of the method for producing the polysiloxane (S) include a method for producing the polysiloxane as the component [A] described above.

The polysiloxane (S) may have a weight average molecular weight of, for example, 500 to 1 million. From the viewpoint of preventing the precipitation of the polysiloxane (S) in the composition, the weight-average molecular weight is preferably 500,000 or less, more preferably 250,000 or less, and still more preferably 100,000 or less. From the viewpoint of the compatibility between storage stability and coatability, the weight-average molecular weight may be preferably 700 or more, more preferably 1,000 or more.

Examples of the solvent contained in the surface modification layer-forming composition (S1) include the component [D]: organic solvent described in the description of the silicon-containing underlayer film-forming composition.

The surface modification layer-forming composition (S1) may contain other components. Examples of the other components include the components described in the description of the silicon-containing underlayer film-forming composition. Examples of the components described in the description of the silicon-containing underlayer film-forming composition include a curing catalyst (component [C]), nitric acid (component [E]), water (component [B]), and other additives.

More preferably, the pH thereof is 3 to 4.

The concentration of the film-forming component in the surface modification layer-forming composition (S1) may be, for example, 0.1 to 50 mass%, 0.1 to 30 mass%, 0.1 to 25 mass%, or 0.5 to 20.0 mass% relative to the total mass of the composition.

The content of the polysiloxane (S) in the film-forming component is ordinarily 20 mass% to 100 mass%. From the viewpoint of achieving the effects of the present invention at high reproducibility or the like, the lower limit value of the content of the polysiloxane is preferably 50 mass%, more preferably 60 mass%, still more preferably 70 mass%, and yet still more preferably 80 mass%. The upper limit value of the content is preferably 99 mass%. The balance may be an additive described below.

Further, the surface modification layer-forming composition (S1) preferably has a pH of 2 to 5, more preferably a pH of 3 to 4.

In the present invention, the surface modification layer-forming composition (S1) may be filtered with a submicrometer-order filter or the like during production of the composition or after mixing of all the components. The type of the material of the filter used is not limited. For example, a nylon-made filter or a fluororesin-made filter may be used.

### <<Surface modification layer-forming composition (S2)>>

As the surface modification layer-forming composition, a composition other than the surface modification layer-forming composition (S1) can be used.

Examples of the surface modification layer-forming composition (S2) include the following compositions.

A substrate treating composition for lithography, including a first monomer, a second monomer, and an acid, wherein
the first monomer is represented by the following Chemical Formula 1,
the second monomer is represented by the following Chemical Formula 7,
a solid content containing the first monomer, the second monomer, and the acid has a molecular weight of 1,000 g/mol to 50,000 g/mol.

   X-Si(R1)₂(R2) ... Chemical formula 1
wherein each of R1 and R2 is an alkyl group having 1 to 20 carbon atoms or an alkoxy group having 1 to 20 carbon atoms, and X is
   i) a cyclic amine or an organic group including the same, or
   ii) an alkyl group having 1 to 20 carbon atoms in which at least one hydrogen is substituted with an amino group, a phenyl group in which at least one hydrogen is substituted with an amino group or a hydroxy group, an ester bond, or a combination thereof.

      Y-Si(R3)₃ ... Chemical formula 7
wherein R3 is an alkoxy group having 1 to 20 carbon atoms, and Y is
   i) a cyclic amine or an organic group including the same, or
   ii) an alkyl group having 1 to 20 carbon atoms in which at least one hydrogen atom is substituted with an amino group, a sulfide bond, an ether bond, an alkyl group having 1 to 20 carbon atoms bonded to a sulfonyl group, or a combination thereof.

Examples of the surface modification layer-forming composition (S2) include the substrate treating composition for lithography described in JP 2019-185008 A. The contents of this publication are incorporated herein in their entirety as if fully set forth.

### <<Surface modification layer-forming composition (S3)>>

As the surface modification layer-forming composition, a composition other than the surface modification layer-forming composition (S1) can be used.

Examples of the surface modification layer-forming composition (S3) include the following surface modifiers.

A surface modifier for a resist pattern, the surface modifier applied to a substrate before a resist pattern having 0.10 µm or less is formed on the substrate to enhance adhesion between the substrate and the resist pattern, the surface modifier including at least one of:
a compound represented by the following average composition formula (1);
a hydrolyzate of a compound represented by the following average composition formula (1); and
a hydrolysis condensate of the compound represented by the following average composition formula (1).
   [Chem. 24]

   **R¹ₐR²_{b}(OX)_{c}SiO_{(4-a-b-c)/2}** **(1)**

In the formula, R¹ represents a monovalent organic group represented by the general formula: -(CH₂)ₙY, and
Y represents a hydrogen atom, an acetoxy group, a γ-butyrolactone group, a C1 to C6 carbinol group optionally substituted with a halogen atom, a norbornene group, a toluyl group, a C1 to C3 alkoxyphenyl group, a C6 to C30 aryl group optionally substituted with a halogen atom or a C1 to C3 alkoxysilyl group, an optionally oxygen-interrupted C1 to C4 alkyl group, a phenylsulfonamide group, a monovalent group derived from a cyclic amide optionally substituted with a C1 to C3 alkyl group or a C2 to C5 alkenyl group, a monovalent group derived from a cyclic imide optionally substituted with a C1 to C3 alkyl group or a C2 to C5 alkenyl group, a C3 to C6 cyclic alkenyl group optionally substituted with a C1 to C3 alkyl group or a C2 to C5 alkenyl group, a phenylsulfone group, a p-tolylsulfonyl group, a p-toluenesulfonyl group, or a monovalent group represented by the following formula (1-1) or (1-2) (* represents a bond.), 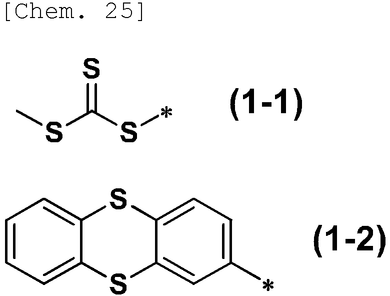
n is an integer of 0 to 4,
R² is a C1 to C4 monovalent hydrocarbon group,
X represents a hydrogen atom or a monovalent hydrocarbon group of C1 to C4,
a is 1 to 2,
b is 0 to 1,
c is a number of 0 to 2, and
a + b + c ≤ 4.

Examples of the surface modification layer-forming composition (S3) include a surface modifier for a resist pattern described in WO 2019/198700 A. The contents of this publication are incorporated herein in their entirety as if fully set forth.

The method for forming the surface modification layer is not particularly limited, and examples thereof include applying the surface modification layer-forming composition onto the silicon-containing underlayer film.

Examples of the coating method include appropriate coating methods such as a spinner and a coater.

After coating, heating (baking) may be performed as necessary.

The heating can be performed using, for example, a heating means such as a hot plate.

In addition, as a method for forming the surface modification layer, the following method may be used.

A method including: applying a surface modification layer-forming composition onto a silicon-containing underlayer film to form a surface modification layer precursor; and then bringing the surface modification layer precursor into contact with a thinning liquid to thin the surface modification layer precursor, thereby obtaining a surface modification layer having a film thickness of 5 nm or less.

As a result of this process, the surface modification layer precursor is thinned to the extent that the components in the surface modification layer precursor are transferred to the thinning liquid. Consequently, a surface modification layer having a film thickness of 5 nm or less is formed.

The method of bringing the surface modification layer precursor into contact with the thinning liquid is not particularly limited. Spin coating is preferred from the viewpoint that the thickness can be uniformly thinned and the degree of thinning can be easily controlled with high accuracy. That is, it is preferable that the surface modification layer precursor is spin-coated with a thinning liquid to thin the surface modification layer precursor and to form a surface modification layer having a film thickness of 5 nm or less.

The thinning liquid is not particularly limited as long as it is a liquid in which the surface modification layer precursor is brought into contact with the thinning liquid to thin the surface modification layer precursor, and examples thereof include an organic solvent, water, an acidic solution, and an alkaline aqueous solution. Alternatively, a thinner used in a reducing resist comsumption (RRC) step or an edge bead removing (EBR) step can be used. These materials can be used singly or in combination of two or more kinds thereof.

Examples of the organic solvent include alcohols, alkylene glycol alkyl ethers, and alkylene glycol monoalkyl ether carboxylic acid esters.

Examples of the alcohols include a monoalcohol-based solvent and a polyhydric alcohol-based solvent. Specific examples of the monoalcohol-based solvent and the polyhydric alcohol-based solvent include the monoalcohol-based solvents and polyhydric alcohol-based solvents described above as the solvents used for hydrolysis and condensation.

Examples of the alkylene glycol alkyl ethers include alkylene glycol monoalkyl ethers and alkylene glycol dialkyl ethers.

Examples of the alkylene glycol monoalkyl ether include ethylene glycol monomethyl ether, ethylene glycol monoethyl ether, ethylene glycol monopropyl ether, ethylene glycol monobutyl ether, propylene glycol monomethyl ether (1-methoxy-2-propanol), propylene glycol monoethyl ether (1-ethoxy-2-propanol), methyl isobutyl carbinol, and propylene glycol monobutyl ether.

Examples of the alkylene glycol dialkyl ether include diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, and propylene glycol dibutyl ether.

Examples of the alkylene glycol monoalkyl ether carboxylic acid esters include alkylene glycol monoalkyl ether acetate.

Examples of the alkylene glycol monoalkyl ether acetate include methyl cellosolve acetate, ethyl cellosolve acetate, propylene glycol monomethyl ether acetate (1-methoxy-2-propanol monoacetate), propylene glycol monoethyl ether acetate, propylene glycol monopropyl ether acetate, propylene glycol monobutyl ether acetate, ethylene glycol monomethyl ether acetate, ethylene glycol monoethyl ether acetate, ethylene glycol monopropyl ether acetate, and ethylene glycol monobutyl ether acetate.

Specific examples of other organic solvents include toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, ethyl 2-hydroxy-2-methylpropionate, methyl 3-methoxy-2-methylpropionate, methyl 2-hydroxyisobutyrate, methyl 3-hydroxyisobutyrate, methyl 2-hydroxy-3-methylbutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, methyl propyl ketone, methyl butyl ketone, 2-heptanone, 3-heptanone, 4-heptanone, N,N-dimethylformamide, N-methylacetamide, N,N-dimethylacetamide, N-methyl-2-pyrrolidone, 4-methyl-2-pentanol, and γ-butyrolactone.

Examples of the acidic solution include an inorganic acid aqueous solution, an organic acid aqueous solution, and an organic acid solution. Examples of the inorganic acid aqueous solution include a hydrochloric acid aqueous solution, a nitric acid aqueous solution, a phosphoric acid aqueous solution, a sulfuric acid aqueous solution, and a perchloric acid aqueous solution. Examples of the organic acid aqueous solution include an acetic acid aqueous solution, a trifluoroacetic acid aqueous solution, a camphorsulfonic acid aqueous solution, a p-toluenesulfonic acid aqueous solution, and a trifluoromethanesulfonic acid aqueous solution. Examples of the organic acid solution include a solution prepared by replacing water in the organic acid aqueous solution with an organic solvent. Examples of the organic solvent include alkylene glycol alkyl ethers and alkylene glycol monoalkyl ether carboxylic acid esters.

Examples of the alkaline aqueous solution include developers used in a lithography process.

Examples of the alkaline aqueous solution include an inorganic alkaline aqueous solution and an organic alkaline aqueous solution. Examples of the inorganic alkaline aqueous solution include a potassium hydroxide aqueous solution, a sodium hydroxide aqueous solution, a sodium carbonate aqueous solution, a potassium carbonate aqueous solution, a sodium hydrogen carbonate aqueous solution, a potassium hydrogen carbonate aqueous solution, a sodium phosphate aqueous solution, and a potassium phosphate aqueous solution. Examples of the organic alkaline aqueous solution include a tetramethylammonium hydroxide aqueous solution, a tetraethylammonium hydroxide aqueous solution, a tetrabutylammonium hydroxide aqueous solution, a monoethanolamine aqueous solution, a diethanolamine aqueous solution, and a triethanolamine aqueous solution.

The concentration of the alkali in the alkaline aqueous solution is not particularly limited.

The reducing resist consumption (RRC) step is a step for reducing the amount of photoresist used, and is a step for treating the surface of a substrate with a thinner before applying the photoresist to uniformly apply a small amount of photoresist to the entire surface of the substrate.

The edge bead removing (EBR) step is a step for removing unnecessary residues and other contaminants of a photoresist applied to the end portion or the rear surface portion of the substrate in the coating process.

Examples of the thinner used in the RRC step and the EBR step include propylene glycol monomethyl ether, propylene glycol monomethyl ether acetate, propylene glycol monoethyl ether, cyclohexanone, ethyl lactate, γ-butyrolactone, ethyl 3-ethoxypropionate, methyl hydroxyisobutyrate, and mixtures thereof.

The film thickness of the surface modification layer is not particularly limited as long as it is 5 nm or less, and may be, for example, 0.1 nm to 5 nm, 0.1 nm to 4.5 nm, 0.2 nm to 4.5 nm, 0.2 nm to 4 nm, 0.5 nm to 4 nm, 0.5 nm to 3.5 nm, or 0.5 nm to 3 nm.

The film thickness can be measured, for example, under the following conditions.
· Measurement device name: Ellipsometric film thickness measurement device RE-3100 (SCREEN Holdings Co., Ltd.)
· Single wavelength ellipsometer (SWE) mode
· Arithmetic average of measurements at 8 points (for example, measurement is made at 8 points at intervals of 1 cm in X direction of wafer)

### (Silicon-containing underlayer film, semiconductor processing substrate, and method for forming a pattern, and method for producing semiconductor element)

Hereinafter, as one aspect of the present invention, a silicon-containing underlayer film, a semiconductor processing substrate, a method for forming a pattern, and a method for producing a semiconductor element, using the silicon-containing underlayer film-forming composition of the present invention, will be described.

The silicon-containing underlayer film of the present invention is a cured product of the silicon-containing underlayer film-forming composition of the present invention.

The semiconductor processing substrate of the present invention is provided with the silicon-containing underlayer film of the present invention.

The method for producing a semiconductor element according to the present invention, the method including:
a step of forming an organic underlayer film on a substrate;
a step of forming a silicon-containing underlayer film using the silicon-containing underlayer film-forming composition of the present invention on the organic underlayer film;
a step of forming a surface modification layer on the silicon-containing underlayer film; and
a step of forming a resist film on the surface modification layer.

The method for forming a pattern according to the present invention, the method including:
a step of forming an organic underlayer film on a semiconductor substrate;
a step of applying the silicon-containing underlayer film-forming composition of the present invention on the organic underlayer film and baking the composition to form a silicon-containing underlayer film;
a step of forming a surface modification layer on the silicon-containing underlayer film;
a step of forming a resist film on the surface modification layer;
a step of exposing and developing the resist film to obtain a resist pattern;
a step of etching the surface modification layer and the silicon-containing underlayer film using the resist pattern as a mask; and
a step of etching the organic underlayer film using the patterned surface modification layer and silicon-containing underlayer film as a mask.

First, the silicon-containing underlayer film-forming composition of the present invention is applied onto a substrate used for producing a precision integrated circuit element [for example, a semiconductor substrate such as a silicon wafer coated with a silicon oxide film, a silicon nitride film, or a silicon oxynitride film, a silicon nitride substrate, a quartz substrate, a glass substrate (including alkali-free glass, low-alkali glass, and crystallized glass), a glass substrate on which an indium tin oxide (ITO) film or an indium zinc oxide (IZO) film is formed, a plastic (polyimide, PET, or the like) substrate, a low dielectric constant material (low-k material)-coated substrate, a flexible substrate, or the like] by an appropriate application method such as a spinner or a coater, and then baked using a heating means such as a hot plate to form a cured product of the composition, thereby forming a silicon-containing underlayer film. Hereinafter, in this specification, the term "silicon-containing underlayer film" refers to a film formed from the silicon-containing underlayer film-forming composition of the present invention.

The baking conditions are appropriately selected from a baking temperature of 40°C to 400°C, or 80°C to 250°C, and a baking time of 0.3 minutes to 60 minutes. Preferably, the baking temperature is 150°C to 250°C, and the baking time is 0.5 minutes to 2 minutes.

The film thickness of the silicon-containing underlayer film formed herein is, for example, 5 nm to 100 nm, 10 nm to 50 nm, 10 nm to 30 nm, 10 nm to 25 nm, or 10 to 20 nm.

As the silicon-containing underlayer film-forming composition, the silicon-containing underlayer film-forming composition filtered through a nylon filter may be used. Herein, the term "silicon-containing underlayer film-forming composition filtered through a nylon filter" refers to a composition that has been subjected to filtration with a nylon filter during production of the silicon-containing underlayer film-forming composition or after mixing all the components.

The present invention includes an aspect in which an organic underlayer film is formed on a substrate, then a silicon-containing underlayer film is formed thereon, and a surface modification layer is further formed thereon, but may include an aspect in which an organic underlayer film is not provided in some cases.

The organic underlayer film used herein is not particularly limited, and may be optionally selected from organic underlayer films commonly used in the lithography process.

In one aspect, the organic underlayer film is formed on the substrate, and the silicon-containing underlayer film is formed on the organic underlayer film, and the surface modification layer is formed on the silicon-containing underlayer film, followed by formation of a resist film as described below on the surface modification layer. This can narrow the pattern width of a resist film. Thus, even when the resist film is formed thinly for preventing pattern collapse, the substrate can be processed through selection of an appropriate etching gas described below. For example, the surface modification layer and the silicon-containing underlayer film can be processed using a fluorine-based gas, as an etching gas, having a sufficiently high etching rate with respect to the surface modification layer and the silicon-containing underlayer film and using a resist pattern as an etching mask. In addition, the organic underlayer film can be processed using an oxygen-based gas, as an etching gas, having a sufficiently high etching rate with respect to the organic underlayer film and using the patterned surface modification layer and silicon-containing underlayer film as an etching mask. Further, the substrate can be processed using a fluorine-based gas, as an etching gas, having a sufficiently high etching rate with respect to the substrate and using a patterned organic underlayer film as an etching mask.

The substrate and coating method usable in this process include those described above.

In addition, the step of forming the silicon-containing underlayer film may include at least one of dry etching treatment, baking treatment at 250°C or more, and UV irradiation treatment. For example, these treatments are used for the cured product that has been obtained by applying the silicon-containing underlayer film-forming composition to an object to be coated, and then baking the composition.

These treatments are particularly effective for improving the film formability of the surface modification layer when the silicon-containing underlayer film-forming composition contains a curing catalyst.

Conditions for the dry etching treatment are not particularly limited.

The atmosphere gas in the dry etching treatment is not particularly limited, and examples thereof include an atmosphere gas containing at least one of an oxygen gas, a hydrogen gas, a nitrogen gas, and a rare gas. Among these, oxygen gas is preferable.

The flow rate of the atmosphere gas in the dry etching treatment is not particularly limited, and is, for example, 10 sccm to 300 sccm.

In the dry etching treatment, the dry etching treatment is ordinarily performed under reduced pressure in order to turn the gas into plasma. The pressure in this case is not particularly limited, and is, for example, 0.1 Pa to 10 Pa.

The baking treatment is ordinarily performed at a temperature higher than the baking temperature at the time of forming the silicon-containing underlayer film. In this regard, the baking treatment is ordinarily performed at 250°C or more. The atmosphere for the baking treatment is not particularly limited, and examples thereof include an air atmosphere and an inert atmosphere. Examples of the inert atmosphere include a nitrogen gas atmosphere. The temperature of the baking treatment may be 250°C to 500°C or 300°C to 450°C. The baking treatment time is, for example, 30 seconds to 10 minutes.

Conditions for the UV irradiation treatment are not particularly limited.

The wavelength (irradiation wavelength) in the UV irradiation treatment is not particularly limited, and is, for example, 170 nm to 370 nm.

The atmosphere of the UV irradiation treatment is not particularly limited, and may be an air atmosphere or an inert atmosphere, but an atmosphere containing oxygen and a nitrogen atmosphere are preferable. From the viewpoint of generating ozone, the atmosphere of the UV irradiation treatment is preferably an atmosphere containing oxygen, and more preferably an air atmosphere.

The radiation source (light source) for the UV irradiation treatment is not particularly limited, and examples thereof include a UV lamp, an excimer UV lamp, an excimer laser, a radiation tube, and an electron gun. Among these, an excimer UV lamp (for example, xenon excimer lamp: center emission wavelength 172 nm) is preferable from the viewpoint of high handleability and high treatment efficiency.

The UV irradiation amount is not particularly limited, and is, for example, 100 mJ/cm² to 10,000 mJ/cm².

For example, a layer of a resist material (resist film) is formed on a surface modification layer. The resist film can be formed by a well-known method. Specifically, the resist film can be formed by applying a coating-type resist material (e.g. a composition for forming a resist film) onto the surface modification layer, and baking the resist material.

The resist film has a film thickness of, for example, 10 nm to 10,000 nm, or 100 nm to 2,000 nm, or 200 nm to 1,000 nm, or 30 nm to 200 nm.

The photoresist material used for the resist film is not particularly limited as long as it is sensitive to light used for exposure (e.g. a KrF excimer laser or an ArF excimer laser), and both a negative photoresist material and a positive photoresist material can be used. Examples of the photoresist include a positive photoresist material formed of a novolac resin and 1,2-naphthoquinone diazide sulfonic acid ester; a chemically amplified photoresist material formed of a binder having a group that is decomposed by an acid to increase an alkali dissolution rate and a photoacid generator; a chemically amplified photoresist material formed of a low molecular weight compound that is decomposed by an acid to increase an alkali dissolution rate of the photoresist material, an alkali-soluble binder, and a photoacid generator; a chemically amplified photoresist material formed of a binder having a group that is decomposed by an acid to increase an alkali dissolution rate, a low molecular weight compound having a group that is decomposed by an acid to increase an alkali dissolution rate of the photoresist material, and photoacid generator.

Specific examples of commercially available products thereof include, but are not limited to, APEX-E (trade name, manufactured by Shipley Company L.L.C), PAR710 (trade name, manufactured by Sumitomo Chemical Co., Ltd.), AR2772JN (trade name, manufactured by JSR Corporation), and SEPR430 (trade name, manufactured by Shin-Etsu Chemical Co., Ltd.). Further, examples of the photoresist include a fluorine-containing atomic polymer-based photoresist material as described in Proc. SPIE, Vol. 3999, 330-334 (2000), Proc. SPIE, Vol. 3999, 357-364 (2000), or Proc. SPIE, Vol. 3999, 365-374 (2000).

In addition, for the resist film, a resist film for electron beam lithography (also referred to as an electron beam resist film) or a resist film for EUV lithography (also referred to as an EUV resist film) can be used instead of the photoresist film, that is, the silicon-containing underlayer film-forming composition of the present invention can be used for forming an underlayer film for electron beam lithography or for forming an underlayer film for EUV lithography. In particular, it is suitable as an underlayer film-forming composition for EUV lithography.

As the electron beam resist material for forming the electron beam resist film, both a negative type material and a positive type material can be used. Specific examples of the negative type material and the positive type material include: a chemically amplified resist material containing an acid generator and a binder having a group that is decomposed by an acid to change the alkali dissolution rate; a chemically amplified resist material containing an alkali-soluble binder, an acid generator, and a low molecular weight compound that is decomposed by an acid to change the alkali dissolution rate of the resist material; a chemically amplified resist material containing an acid generator, a binder having a group that is decomposed by an acid to change the alkali dissolution rate, and a low molecular weight compound that is decomposed by an acid to change the alkali dissolution rate of the resist material; a non-chemically amplified resist material containing a binder having a group that is decomposed by an electron beam to change the alkali dissolution rate; and a non-chemically amplified resist material containing a binder having a moiety that is cleaved by an electron beam to change the alkali dissolution rate. Even when these electron beam resist materials are used, a resist film pattern can be formed similarly to a case in which a photoresist material is used with an electron beam being used as an irradiation source.

In addition, as the EUV resist material for forming the EUV resist film, a methacrylate resin-based resist material or a metal-containing resist can be used.

The metal-containing resist is also called a metal oxide resist (metal oxide resist (MOR)), and typical examples thereof include a tin oxide-based resist.

The material of the metal oxide resist is, for example, a coating composition containing a metal oxo-hydroxo network having an organic ligand through a metal carbon bond and/or a metal carboxylate bond described in JP 2019-113855 A.

In an example of the metal-containing resist, a peroxo ligand is used as a radiation-sensitive stabilizing ligand. Details of the peroxo based metal oxo-hydroxo compounds are described, for example, in paragraph [0011] of JP 2019-532489 A: Patent Literature. Examples of the Patent Literature include US 9,176,377 B2, US 2013/0224652 A1, US 9,310,684 B2, US 2016/0116839 A1, and US 15/291738.

Further, an example of the metal-containing resist will be described below.

A coating including a metal oxo-hydroxo network having an organic ligand via a metal carbon bond and/or a metal carboxylate bond.

An inorganic oxo/hydroxo-based composition.

A coating solution containing: an organic solvent; a first organometallic composition represented by the formula R_{z}SnO_{(2-(z/2)-(x/2))}(OH)ₓ (here, 0 < z ≤ 2 and 0 < (z + x) ≤ 4), the formula R'ₙSnX₄₋ₙ (here, n = 1 or 2), or a mixture thereof, in which R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (here, M represents a metal selected from groups 2 to 16 in the periodic table, v is a number of v = 2 to 6, and X' represents a ligand having a hydrolysable M-X bond or a combination of such ligands).

A coating solution containing an organic solvent and a first organometallic compound represented by the formula RSnO_{(3/2-x/2)}(OH)ₓ (where 0 < x < 3), in which the solution contains from about 0.0025 M to about 1.5 M of tin, R is an alkyl group or a cycloalkyl group having 3 to 31 carbon atoms, and the alkyl group or cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

Other examples of the metal-containing resist include compositions described in JP 2011-253185 A, WO 2015/026482 A, WO 2016/065120 A, WO 2017/066319 A, WO 2017/156388 A, WO 2018/031896 A, JP 2020-122959 A, JP 2020-122960 A, WO 2019/099981 A, WO 2019/199467 A, WO 2019/195522 A, WO 2019/195522 A, WO 2020/210660 A, WO 2021/011367 A, and WO 2021/016229 A.

These contents are incorporated herein to the same extent as all the contents are specified.

The method for forming the metal-containing resist film from the metal-containing resist is not particularly limited, and examples thereof include a method in which a coating-type resist material (metal-containing resist film-forming composition) as the metal-containing resist is applied and fired.

The metal-containing resist film may be formed by vapor deposition. The method for forming the metal-containing resist film by vapor deposition is, for example, a method described in JP 2017-116923 A. The contents of JP 2017-116923 A are incorporated herein to the same extent as all the contents are specified. In JP 2017-116923 A, the metal-containing resist film in the present invention is referred to as a metal oxide-containing film.

Subsequently, light exposure is performed on the resist film through a predetermined mask (reticle). The light exposure may be performed using a KrF excimer laser (wavelength: 248 nm), an ArF excimer laser (wavelength: 193 nm), an F₂ excimer laser (wavelength: 157 nm), EUV (wavelength: 13.5 nm), electron beams, or the like.

After the light exposure, post exposure bake may be performed as necessary. The post exposure bake is performed under appropriately selected conditions: a heating temperature of 70°C to 150°C and a heating time of 0.3 minutes to 10 minutes.

Then, development is performed with a developer (e.g. an alkaline developer). When, for example, a positive photoresist film is used, an exposed portion of the photoresist film is removed, and thus a pattern of the photoresist film is formed.

Examples of the developer (alkaline developer) include alkaline aqueous solutions (alkaline developers) such as: aqueous solutions of alkali metal hydroxides such as potassium hydroxide and sodium hydroxide; aqueous solutions of quaternary ammonium hydroxides such as tetramethylammonium hydroxide, tetraethylammonium hydroxide, and choline; and aqueous amine solutions such as ethanolamine, propylamine, and ethylenediamine. Further, a surfactant or the like may be added to these developers. Development conditions are appropriately selected from a temperature of 5 to 50°C, and a time of 10 seconds to 600 seconds.

In the present invention, an organic solvent can be used as a developer. Development is performed with a developer (solvent) after light exposure. As a result, for example, when a negative resist film (for example, metal-containing resist film) is used, the resist film in an unexposed portion is removed, and a pattern of the resist film is formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Further, a surfactant or the like may be added to these developers. Development conditions are appropriately selected from a temperature of 5°C to 50°C, and a time of 10 seconds to 600 seconds.

The pattern of the resist film (upper layer) thus formed is used as a protective film to remove the surface modification layer and the silicon-containing underlayer film (intermediate layer), and then the patterned surface modification layer and silicon-containing underlayer film (intermediate layer) are used as a protective film to remove the organic underlayer film (underlayer). Finally, the substrate is processed using the patterned organic underlayer film (underlayer) as a protective film.

When the organic underlayer film (underlayer) is removed, a part of the resist pattern may remain on the patterned surface modification layer and silicon-containing underlayer film.

In addition, when the substrate is processed, a part of the patterned silicon-containing underlayer film may remain on the patterned organic underlayer film.

The surface modification layer and silicon-containing underlayer film (intermediate layer) are removed (patterned) through dry etching by using the patterned resist film (upper layer) as a protective film. The dry etching can be performed using any of these gases, such as tetrafluoromethane (CF₄), perfluorocyclobutane (C₄F₈), perfluoropropane (C₃F₈), trifluoromethane, carbon monoxide, argon, oxygen, nitrogen, sulfur hexafluoride, difluoromethane, nitrogen trifluoride, chlorine trifluoride, chlorine, trichloroborane, and dichloroborane.

The dry etching of the surface modification layer and silicon-containing underlayer film is preferably performed using a halogen-containing gas. The resist film (photoresist film) made of an organic material is basically less likely to be removed by dry etching with a halogen-containing gas. In contrast, for example, the surface modification layer and silicon-containing underlayer film containing numerous silicon atoms are rapidly removed by a halogen-containing gas. Accordingly, a reduction in the film thickness of the resist film in association with the dry etching of the surface modification layer and silicon-containing underlayer film can be suppressed. As a result, the resist film can be used in the form of thin film. Therefore, the dry etching of the silicon-containing underlayer film is preferably performed using a fluorine-containing gas, and examples of the fluorine-containing gas include, but are not limited to, tetrafluoromethane (CF₄), perfluorocyclobutane (C₄F₈), perfluoropropane (C₃F₈), trifluoromethane, and difluoromethane (CH₂F₂).

When the organic underlayer film is provided between the substrate and the silicon-containing underlayer film, the organic underlayer film (lower layer) is preferably removed (patterned) by dry etching with an oxygen-based gas (oxygen gas, oxygen/carbonyl sulfide (COS) mixed gas, and the like) using the patterned resist film (upper layer) (when the patterned resist film (upper layer) remains) and the patterned surface modification layer and silicon-containing underlayer film (intermediate layer) as protective films. This is because the silicon-based underlayer film of the present invention, which contains numerous silicon atoms, is less likely to be removed by dry etching with an oxygen-containing gas.

In addition, using the surface modification layer and the silicon-containing underlayer film instead of the conventional single-layer silicon-containing resist underlayer film allows the silicon-containing underlayer film to have a composition specialized for imparting etching resistance, thus allowing the thickness of the silicon-containing underlayer film to be further reduced.

Thereafter, the patterned surface modification layer and silicon-containing underlayer film (intermediate layer) and, if desired, the patterned organic underlayer film (underlayer) are used as protective films to process (pattern) the (semiconductor) substrate. The (semiconductor) substrate is preferably processed (patterned) by dry etching with a fluorine-based gas.

Examples of the fluorine-based gas include tetrafluoromethane (CF₄), perfluorocyclobutane (C₄F₈), perfluoropropane (C₃F₈), trifluoromethane, and difluoromethane (CH₂F₂).

After the removal (patterning) of the organic underlayer film or after the processing (patterning) of the substrate, the surface modification layer and silicon-containing underlayer film may be removed. The surface modification layer and silicon-containing underlayer film may be removed by dry etching or wet etching (wet method).

The dry etching of the surface modification layer and silicon-containing underlayer film is preferably performed with a fluorine-containing gas as described in the patterning. Examples of the fluorine-containing gas include, but are not limited to, tetrafluoromethane (CF₄), perfluorocyclobutane (C₄F₈), perfluoropropane (C₃F₈), trifluoromethane, and difluoromethane (CH₂F₂).

Examples of the chemical used for wet etching of the surface modification layer and silicon-containing underlayer film include alkaline solutions, such as dilute hydrofluoric acid (hydrofluoric acid), buffered hydrofluoric acid (mixed solution of HF and NH₄F), an aqueous solution containing hydrochloric acid and hydrogen peroxide (SC-2 chemical), an aqueous solution containing sulfuric acid and hydrogen peroxide (SPM chemical), an aqueous solution containing hydrofluoric acid and hydrogen peroxide (FPM chemical), and an aqueous solution containing ammonia and hydrogen peroxide (SC-1 chemical). Further, examples of the alkaline chemical solution include an aqueous solution containing 1 to 99 mass% of ammonia, tetramethylammonium hydroxide (TMAH), tetraethylammonium hydroxide, tetrapropylammonium hydroxide, tetrabutylammonium hydroxide, choline hydroxide, benzyltrimethylammonium hydroxide, benzyltriethylammonium hydroxide, diazabicycloundecene (DBU), diazabicyclononene (DBN), hydroxylamine, 1-butyl-1-methylpyrrolidinium hydroxide, 1-propyl-1-methylpyrrolidinium hydroxide, 1-butyl-1-methylpiperidinium hydroxide, 1-propyl-1-methylpiperidinium hydroxide, mepiquat hydroxide, trimethylsulfonium hydroxide, a hydrazine compound, an ethylenediamine compound, or guanidine, in addition to the above-described ammonia-hydrogen peroxide mixture prepared by mixing ammonia, hydrogen peroxide water, and water (SC-1 chemical solution). These chemical liquids may be used in the form of mixture.

In addition, the substrate to which the silicon-containing underlayer film-forming composition is applied may have an organic or inorganic bottom anti-reflective coating formed thereon by, for example, a CVD process. The silicon-containing underlayer film may be formed on the anti-reflective coating. Even in a case where the silicon-containing underlayer film of the present invention is formed on the organic underlayer film formed on the substrate, the substrate used may have an organic or inorganic bottom anti-reflective coating formed on the surface thereof by, for example, a CVD process.

The silicon-containing underlayer film formed from the silicon-containing underlayer film-forming composition may absorb light used in a lithography process depending on the wavelength of the light. In such a case, the silicon-containing underlayer film can function as an antireflection film having the effect of preventing reflection of light from the substrate.

The silicon-containing underlayer film can be applied to a substrate having via holes for use in a dual damascene process, and can be used as a hole filling material (embedding material) to fill up the holes without gaps. The silicon-containing underlayer film can also be used as a planarization material for planarizing the surface of a semiconductor substrate having irregularities.

The silicon-containing underlayer film of the present invention functions as an underlayer of EUV resist film or a hard mask. In addition, the silicon-containing underlayer film is capable of, without intermixing with the EUV resist film, preventing the reflection, from a substrate or an interface, of exposure light undesirable for EUV exposure (wavelength: 13.5 nm), such as UV (ultraviolet) light or DUV (deep ultraviolet) light (ArF light, KrF light). Therefore, in order to form the underlayer antireflection film of the EUV resist film, the silicon-containing underlayer film-forming composition of the present invention can be suitably used. Thus, the silicon-containing underlayer film can efficiently prevent the light reflection as the underlayer film of the EUV resist film. When the silicon-containing underlayer film is used as an EUV underlayer film, the film can be processed in a similar manner to the photoresist underlayer film.

When the semiconductor processing substrate including the silicon-containing underlayer film of the present invention described above and a semiconductor substrate is used, the semiconductor substrate can be suitably processed.

In addition, the method for producing a semiconductor element of the present invention as described above can achieve processing of a semiconductor substrate with high accuracy with high reproducibility, and thus stable production of a semiconductor element can be expected.

### Examples

Hereinafter, the present invention will be described more specifically with reference to synthesis examples and examples, but the present invention is not limited to only the examples described below.

In the Examples, apparatuses and conditions used for analysis of the physical properties of samples are as follows.

### (1) Measurement of molecular weight

The molecular weight of a polysiloxane used in the present invention is a molecular weight obtained in terms of polystyrene by GPC analysis.

Measurement was performed under GPC measurement conditions using a GPC apparatus (trade name: HLC-8220GPC, manufactured by Tosoh Corporation), a GPC column (trade name: Shodex (registered trademark) KF803L, KF802, KF801, manufactured by Showa Denko K.K.), a column temperature of 40°C, with tetrahydrofuran as an eluent (elution solvent), at a flow amount (flow rate) of 1.0 mL/min, with polystyrene (manufactured by Showa Denko K.K.) as a standard sample.

### (2)¹H-NMR

The evaluation was performed using a nuclear magnetic resonance apparatus ¹H-NMR (400 MHz), manufactured by JEOL Ltd., and d6-Acetone as a solvent.

### (3) Amount of residual nitric acid

The amount of nitric acid remaining in the system was measured by ion chromatography evaluation.

### (4) AFM (atomic force microscope)

The film surface roughness was measured with a medium-sized probe microscope system manufactured by Hitachi High-Tech Corporation.

### (5) Film thickness measurement

The film thickness was measured under the following conditions.
· Measurement device name: Ellipsometric film thickness measurement device RE-3100 (SCREEN Holdings Co., Ltd.)
· Single wavelength ellipsometer (SWE) mode
· Arithmetic average of measurements at 8 points (for example, measurement is made at 8 points at intervals of 1 cm in X direction of wafer)

### [1] Synthesis of polymer (hydrolysis condensate)

### (Synthesis Example 1-1)

A 300 mL flask was charged with 23.26 g of tetraethoxysilane, 7.11 g of methyltriethoxysilane, 1.58 g of phenyltrimethoxysilane, and 47.93 g of propylene glycol monoethyl ether. While the resultant mixed solution was stirred with a magnetic stirrer, 20.12 g of 0.1 M aqueous nitric acid solution was added dropwise to the mixed solution.

After the dropwise addition, the flask was transferred to an oil bath set at 60°C and the mixed solution was refluxed for 20 hours. Thereafter, ethanol, methanol, and water as reaction by-products were distilled under reduced pressure and concentrated to obtain a hydrolysis condensate (polymer) solution.

Propylene glycol monoethyl ether was further added, the concentration was adjusted so as to achieve a solvent proportion of propylene glycol monoethyl ether of 100% and a solid residue content of 20 mass% at 140°C, and filtration was performed with a nylon filter (pore size: 0.1 µm).

The resultant polymer contained a polysiloxane having a structure represented by the formula described below and had a weight-average molecular weight of 3,000 as determined by GPC in terms of polystyrene. In addition, the amount capped with propylene glycol monoethyl ether was determined through ¹H-NMR to be 3 mol% relative to Si atoms. In addition, the amount of residual nitric acid in the polymer solution was 1,200 ppm.

The proportion of tetraethoxysilane to the total amount of the hydrolyzable silanes blended was 70 mol%.

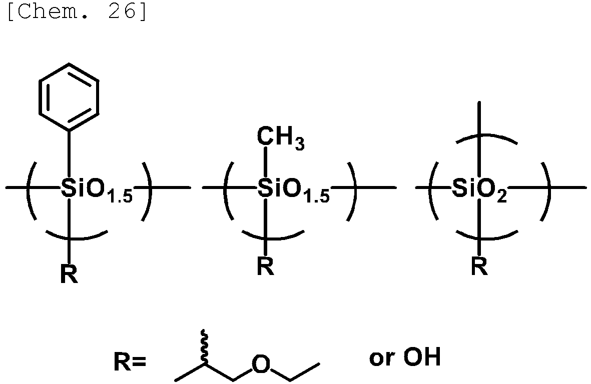

### (Synthesis Example 1-2)

A 300 mL flask was charged with 23.0 g of tetraethoxysilane, 7.0 g of methyltriethoxysilane, 2.02 g of bicyclo[2.2.1]hept-5-en-2-yltriethoxysilane, and 48.1 g of propylene glycol monoethyl ether. While the resultant mixed solution was stirred with a magnetic stirrer, 19.9 g of an aqueous nitric acid solution (0.1 mol/L) was added dropwise to the mixed solution.

After the dropwise addition, the flask was transferred to an oil bath set at 60°C and the mixed solution was refluxed for 20 hours. Thereafter, ethanol and water as reaction by-products were distilled under reduced pressure and concentrated to obtain a hydrolysis condensate (polymer) solution.

Propylene glycol monoethyl ether was further added, the concentration was adjusted so as to achieve a solvent proportion of propylene glycol monoethyl ether of 100% and a solid residue content of 20 mass% at 140°C, and filtration was performed with a nylon filter (pore size: 0.1 µm).

The resultant polymer contained a polysiloxane having a structure represented by the formula described below and had a weight-average molecular weight Mw of 2,800 as determined by GPC in terms of polystyrene. In addition, the amount capped with propylene glycol monoethyl ether was determined through ¹H-NMR to be 3 mol% relative to Si atoms. In addition, the amount of residual nitric acid in the polymer solution was 1,200 ppm.

The proportion of tetraethoxysilane to the total amount of the hydrolyzable silanes blended was 70 mol%.

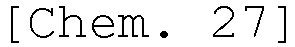

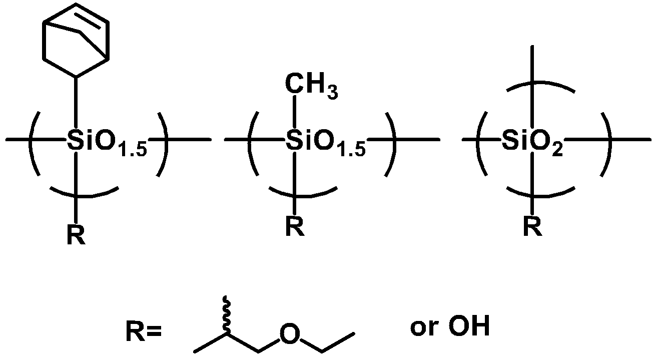

### (Synthesis Example 1-3)

A 300 mL flask was charged with 22.3 g of tetraethoxysilane, 6.82 g of methyltriethoxysilane, 3.16 g of diallyl isocyanurate propyltriethoxysilane, and 48.4 g of propylene glycol monoethyl ether, and while the mixed solution was stirred with a magnetic stirrer, 19.3 g of a nitric acid aqueous solution (0.1 mol/L) was added dropwise thereto.

After the dropwise addition, the flask was transferred to an oil bath set at 60°C and the mixed solution was refluxed for 20 hours. Thereafter, ethanol and water as reaction by-products were distilled under reduced pressure and concentrated to obtain a hydrolysis condensate (polymer) solution.

Propylene glycol monoethyl ether was further added to the solution, the concentration was adjusted so as to achieve a solvent proportion of propylene glycol monoethyl ether of 100% and a solid residue content of 20 mass% at 140°C, and filtration was performed with a nylon filter (pore size: 0.1 µm).

The resultant polymer was found to contain a polysiloxane including a structure represented by the following Formula, and to have a weight-average molecular weight Mw of 2,300 as determined by GPC in terms of polystyrene. In addition, from ¹H-NMR, the amount capped with propylene glycol monoethyl ether was 2 mol% relative to Si atoms. In addition, the amount of residual nitric acid in the polymer solution was 1,200 ppm.

The proportion of tetraethoxysilane to the total amount of the hydrolyzable silanes blended was 70 mol%.

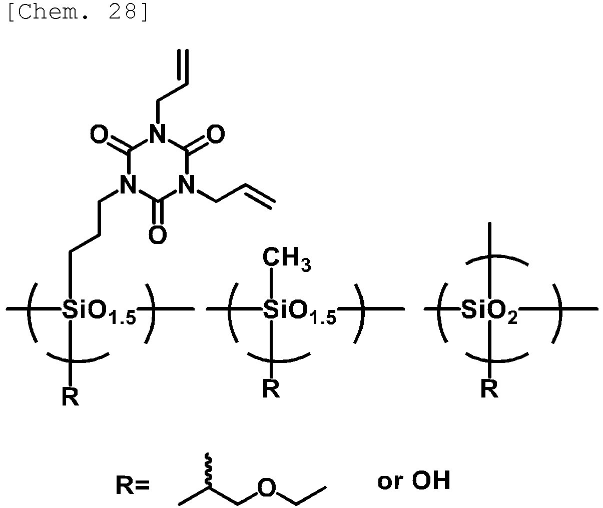

### (Synthesis Example 1-4)

A 300 mL flask was charged with 26.4 g of tetraethoxysilane, 5.64 g of methyltriethoxysilane, 48.0 g of propylene glycol monoethyl ether, and while the mixture solution was stirred with a magnetic stirrer, 20.0 g of aqueous nitric acid solution (0.1 mol/L) was added dropwise.

After the dropwise addition, the flask was transferred to an oil bath set at 60°C and the mixed solution was refluxed for 20 hours. Thereafter, ethanol and water as reaction by-products were distilled under reduced pressure and concentrated to obtain a hydrolysis condensate (polymer) solution.

Propylene glycol monoethyl ether was further added to the solution, the concentration was adjusted so as to achieve a solvent proportion of propylene glycol monoethyl ether of 100% and a solid residue content of 20 mass% at 140°C, and filtration was performed with a nylon filter (pore size: 0.1 µm).

The resultant polymer contained a polysiloxane including a structure represented by the following formula, and had a weight-average molecular weight Mw of 2,900 as determined by GPC in terms of polystyrene. In addition, the amount capped with propylene glycol monoethyl ether was determined through ¹H-NMR to be 3 mol% relative to Si atoms. In addition, the amount of residual nitric acid in the polymer solution was 1,300 ppm.

The proportion of tetraethoxysilane to the total amount of the hydrolyzable silanes blended was 80 mol%.

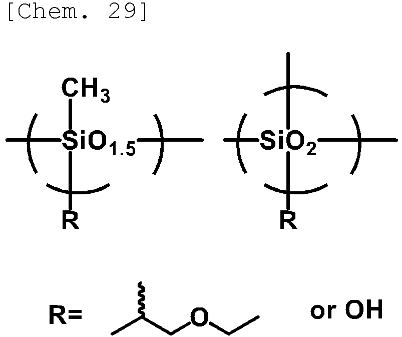

### (Synthesis Example 1-5)

A 300 mL flask was charged with 32.2 g of tetraethoxysilane and 48.3 g of propylene glycol monoethyl ether. While the resultant mixed solution was stirred with a magnetic stirrer, 19.5 g of nitric acid aqueous solution (0.1mol/L) was added dropwise to the mixed solution.

After the dropwise addition, the flask was transferred to an oil bath set at 60°C and the mixed solution was refluxed for 20 hours. Thereafter, ethanol and water as reaction by-products were distilled under reduced pressure and concentrated to obtain a hydrolysis condensate (polymer) solution.

Propylene glycol monoethyl ether was further added to the solution, the concentration was adjusted so as to achieve a solvent proportion of propylene glycol monoethyl ether of 100% and a solid residue content of 20 mass% at 140°C, and filtration was performed with a nylon filter (pore size: 0.1 µm).

The resultant polymer was found to contain a polysiloxane including a structure represented by the following Formula, and to have a weight-average molecular weight Mw of 4,300 as determined by GPC in terms of polystyrene. In addition, the amount capped with propylene glycol monoethyl ether was determined through ¹H-NMR to be 3 mol% relative to Si atoms. In addition, the amount of residual nitric acid in the polymer solution was 1,200 ppm.

The proportion of tetraethoxysilane to the total amount of the hydrolyzable silanes blended was 100 mol%.

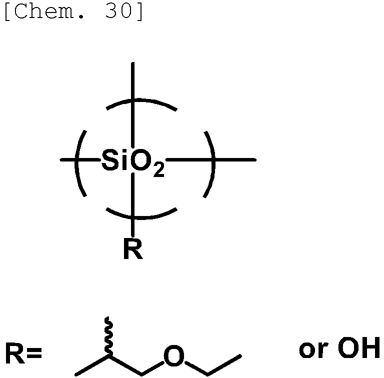

### [2] Preparation of silicon-containing underlayer film-forming composition

The polysiloxane (polymer) obtained in the above Synthesis Examples 1-1 to 1-5, the acid (additive 1), the photoacid generator (additive 2), and the solvent were mixed in the proportions shown in Table 1, and the mixture was filtered through a 0.1-µm fluororesin filter to prepare each of silicon-containing underlayer film-forming compositions 1 to 6. In Table 1, the amount of each component added is shown by part(s) by mass.

Although the composition was prepared from the solution containing the hydrolysis condensate (polymer) produced in each Synthesis Example, the amount of each polymer shown in Table 1 corresponds not to the amount of the polymer solution, but to the amount of the polymer itself.

Abbreviations in Tables 1 and 2 mean the following.
· MA: maleic acid
· TPSNO3: triphenylsulfonium nitrate
· PGEE: propylene glycol monoethyl ether
· PGME: propylene glycol monomethyl ether
· DIW: ultrapure water

**[Table 1]**

| Silicon-containing underlayer film-forming composition | | Polymer | Additive 1 | Additive 2 | Solvent | | |
|---|---|---|---|---|---|---|---|
| Composition 1 | Component | Synthesis Example 1-1 | MA | - | PGEE | PGME | DIW |
| | (parts by mass) | 1 | 0.01 | - | 80 | 8 | 12 |
| Composition 2 | Component | Synthesis Example 1-2 | MA | - | PGEE | PGME | DIW |
| | (parts by mass) | 1 | 0.01 | - | 80 | 8 | 12 |
| Composition 3 | Component | Synthesis Example 1-3 | MA | - | PGEE | PGME | DIW |
| | (parts by mass) | 1 | 0.01 | - | 80 | 8 | 12 |
| Composition 4 | Component | Synthesis Example 1-4 | MA | - | PGEE | PGME | DIW |
| | (parts by mass) | 1 | 0.01 | - | 80 | 8 | 12 |
| Composition 5 | Component | Synthesis Example 1-5 | MA | - | PGEE | PGME | DIW |
| | (parts by mass) | 1 | 0.01 | - | 80 | 8 | 12 |
| Composition 6 | Component | Synthesis Example 1-1 | MA | TPSN03 | PGEE | PGME | DIW |
| | (parts by mass) | 1 | 0.01 | 0.01 | 92 | 8 | 0 |

The silicon-containing underlayer film-forming compositions 1 to 6 further include nitric acid contained in the polymer solution prepared in Synthesis Examples 1 to 5.

### [3] Preparation of organic resist underlayer film-forming composition

In a nitrogen atmosphere, a 100-ml four-necked flask was charged with 6.69 g (0.040 mol) of carbazole (manufactured by Tokyo Chemical Industry Co., Ltd.), 7.28 g (0.040 mol) of 9-fluorenone (manufactured by Tokyo Chemical Industry Co., Ltd.), and 0.76 g (0.0040 mol) of p-toluenesulfonic acid monohydrate (manufactured by Tokyo Chemical Industry Co., Ltd.), and then 6.69 g of 1,4-dioxane (manufactured by Kanto Chemical Co., Inc.) was added to the flask. The resultant mixture was stirred and then heated to 100°C for dissolution, and thus polymerization was initiated. After 24 hours, the mixture was allowed to cool to 60°C.

The cooled reaction mixture was diluted with 34 g of chloroform (manufactured by Kanto Chemical Co., Inc.), and the diluted mixture was added to 168 g of methanol (manufactured by Kanto Chemical Co., Inc.) for precipitation.

The resultant precipitate was subjected to filtration and recovery, and the recovered solid was dried with a reduced-pressure dryer at 80°C for 24 hours to obtain 9.37 g of a desired polymer represented by the formula (X) (hereinafter, abbreviated as PCzFL).

The results of ¹H-NMR measurement of PCzFL were as follows.

¹H-NMR(400MHz, DMSO-d₆): δ7.03-7.55(br, 12H), δ7.61-8.10(br, 4H), δ11.18(br, 1H)
Further, PCzFL was found to have a weight average molecular weight (Mw) of 2,800 as determined by GPC in terms of polystyrene and a polydispersity Mw/Mn of 1.77.

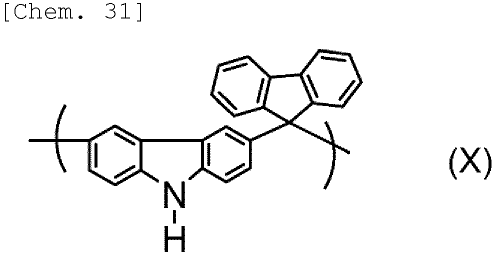

20 g of PCzFL was mixed with 3.0 g of tetramethoxymethyl glycoluril (trade name: Powderlink 1174, manufactured by Cytec Industries Japan (former Mitsui Cytec Ltd.)) serving as a crosslinking agent, 0.30 g of pyridinium para-toluenesulfonate serving as a catalyst, and 0.06 g of MEGAFACE R-30 (trade name, manufactured by DIC Corporation) serving as a surfactant, and the mixture was dissolved in 88 g of propylene glycol monomethyl ether acetate to prepare a solution. Thereafter, the solution was filtered with a polyethylene-made microfilter having a pore size of 0.10 µm, and then filtered with a polyethylene-made microfilter having a pore size of 0.05 µm, to thereby prepare an organic resist underlayer film-forming composition used for a lithography process using a multilayer film.

### [4] Synthesis of polymer (hydrolysis condensate)

### (Synthesis Example 2-1)

A 300 mL flask was charged with 33.42 g of [bicyclo[2.2.1]hept-5-en-2-yl]triethoxysilane and 50.13 g of propylene glycol monoethyl ether. While the resultant mixed solution was stirred with a magnetic stirrer, 16.44 g of 1M nitric acid aqueous solution was added dropwise to the mixed solution.

After the dropwise addition, the flask was transferred to an oil bath set at 120°C and the mixed solution was reacted for 20 hours. Thereafter, ethanol and water as reaction by-products were distilled under reduced pressure and concentrated to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer was found to contain a polysiloxane including a structure represented by the following formula, and to have a weight-average molecular weight Mw of 1200 as determined by GPC in terms of polystyrene. In addition, the amount capped with propylene glycol monoethyl ether was determined through ¹H-NMR to be 5 mol% relative to Si atoms. In addition, the amount of residual nitric acid in the polymer solution was 0.8%.

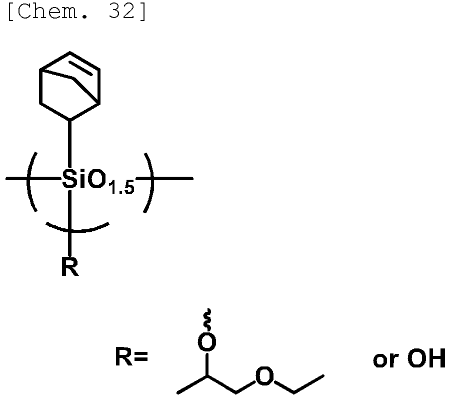

### (Synthesis Example 2-2)

A 300 mL flask was charged with 35.65 g of diallyl isocyanurate propyltriethoxysilane, 53.48 g of propylene glycol monoethyl ether. While the resultant mixed solution was stirred with a magnetic stirrer, 10.87 g of 0.1M nitric acid aqueous solution was added dropwise to the mixed solution.

After the dropwise addition, the flask was transferred to an oil bath set at 120°C and the mixed solution was reacted for 20 hours. Thereafter, ethanol and water as reaction by-products were distilled under reduced pressure and concentrated to obtain a hydrolysis condensate (polymer) solution.

Further, propylene glycol monoethyl ether was added to the resultant solution to achieve a solvent proportion of propylene glycol monoethyl ether of 100% and a concentration of 20 mass% in terms of solid residue at 140°C. The resultant solution was subjected to filtration with a nylon-made filter (pore size: 0.1 µm).

The resultant polymer contained a polysiloxane including a structure represented by the following formula, and had a weight-average molecular weight Mw of 2,300 as determined by GPC in terms of polystyrene. In addition, the amount capped with propylene glycol monoethyl ether was determined through ¹H-NMR to be 6 mol% relative to Si atoms. In addition, the amount of residual nitric acid in the polymer solution was 0.07%.

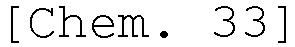

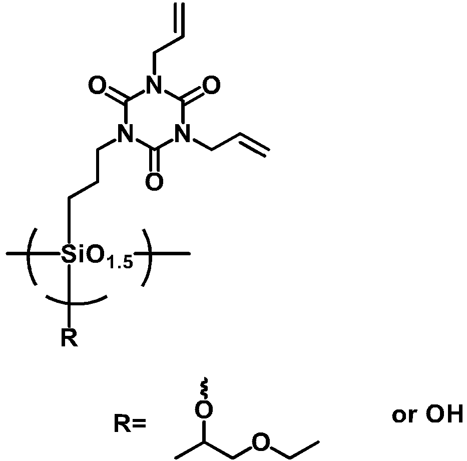

### [5] Preparation of surface modification layer-forming composition

The polysiloxane (polymer) obtained in each of Synthesis Examples 2-1 to 2-2 described above, an acid (additive 1), and a solvent were mixed in proportions shown in Table 2. The resultant mixture was filtered through a 0.1 µm fluororesin filter, and thus each of the surface modification layer-forming compositions 1 and 2 was prepared. In Table 2, the amount of each component added is shown by parts by mass.

Although the composition was prepared from the solution containing the hydrolysis condensate (polymer) produced in each Synthesis Example, the amount of each polymer shown in Table 2 corresponds not to the amount of the polymer solution, but to the amount of the polymer itself.

**[Table 2]**

| Surface modification layer-forming composition | | Polymer | Additive 1 | Additive 2 | Solvent | | |
|---|---|---|---|---|---|---|---|
| Composition 1 | Component | Synthesis Example 2-1 | MA | TPSN03 | PGEE | PGME | DIW |
| | (parts by mass) | 0.1 | 0.001 | 0.001 | 80 | 8 | 12 |
| Composition 2 | Component | Synthesis Example 2-2 | MA | - | PGEE | PGME | DIW |
| | (parts by mass) | 0.1 | 0.001 | - | 92 | 8 | 0 |

### [6] Film formability test of surface modification layer-forming composition

Each of the silicon-containing underlayer film-forming compositions 1 to 6 was applied onto a silicon wafer using a spinner. The resultant wafers were heated on a hot plate at 215°C for 1 minute to form Si-containing underlayer films. For Examples 6 to 8, thereafter, as pre-treatment, O₂ etching treatment (oxygen plasma etching treatment: O₂ 40sccm, 100 W, 8 Pa, 60 sec), 400 degree baking (1 min under N₂), and 172 nm UV irradiation (1000 mJ/cm² in the air under ozone-generating conditions) were respectively performed.

Thereafter, each of the surface modification layer-forming compositions 1 and 2 was applied onto each Si-containing underlayer film, and then heated on a hot plate at 180°C for 1 minute, and further rinsed with a solution of propylene glycol monomethyl ether/propylene glycol monomethyl ether acetate = 7/3 (mass ratio) (thinning liquid), and thinned to form a surface modification layer. As described above, a Si-containing underlayer film having a surface modification layer (film thickness: 1 nm) thereon was obtained. Thereafter, the surface modification layer was observed with an AFM, and a film having a surface roughness value Sa of 0.3 nm or less was evaluated as "favorable", and a film having a surface roughness value Sa of more than 0.3 nm was evaluated as "poor".

The obtained results are shown in Table 3.

**[Table 3]**

| | Si-containing underlayer film-forming composition | Pre-treatment | Coatability | |
|---|---|---|---|---|
| | | | Surface modification layer-forming composition 1 | Surface modification layer-forming composition 2 |
| Example 1 | 1 | None | Favorable | Favorable |
| Example 2 | 2 | None | Favorable | Favorable |
| Example 3 | 3 | None | Favorable | Favorable |
| Example 4 | 4 | None | Favorable | Favorable |
| Example 5 | 5 | None | Favorable | Favorable |
| Example 6 | 6 | 02 etching | Favorable | Favorable |
| Example 7 | 6 | 400 degree baking | Favorable | Favorable |
| Example 8 | 6 | 172 nm UV irradiation (in the air) | Favorable | Favorable |
| Comparative Example 1 | 6 | None | Poor | Poor |

### [7] Formation of resist pattern by EUV exposure: positive solvent development

### (Example 9)

The organic resist underlayer film-forming composition was applied onto a silicon wafer using a spinner, and baked on a hot plate at 215°C for 60 seconds to form an organic underlayer film (A layer) having a film thickness of 60 nm.

The silicon-containing underlayer film-forming composition 1 was applied thereon by spin coating, and heated at 215°C for 1 minute to form a Si-containing underlayer film (B layer) (20 nm). Thereafter, the surface modification layer-forming composition 1 was applied onto the Si-containing underlayer film, and then heated on a hot plate at 180°C for 1 minute, and further rinsed with a solution of propylene glycol monomethyl ether/propylene glycol monomethyl ether acetate = 7/3 (mass ratio) (thinning liquid), and thinned to form a surface modification layer. As described above, a Si-containing underlayer film having a surface modification layer (film thickness: 1 nm) thereon was obtained.

Further, a resist solution for EUV (methacrylate resinbased resist) was applied thereon by spin coating, and heated at 110°C for 1 minute to form an EUV resist film (C layer), and then the EUV resist film (C layer) was exposed using an EUV exposure apparatus (NXE3400) manufactured by ASML under the conditions of NA = 0.33, σ = 0.60/0.82, and Quadropole.

After the exposure, post exposure bake (PEB, at 105°C, for 1 minute) was performed, and then the resist layer was cooled on a cooling plate to room temperature, followed by development with a 2.38% TMAH developer for 30 seconds and rinsing treatment to form a resist pattern.

### (Example 10)

A resist pattern was formed in the same manner as in Example 9 except that the silicon-containing underlayer film-forming composition 5 was used.

### (Example 11)

The silicon-containing underlayer film-forming composition 1 was applied on the organic underlayer film by spin coating, heated at 215°C for 1 minute, and then subjected to an O₂ etching treatment (oxygen plasma etching treatment: O₂ 40 sccm, 100 W, 8 Pa, 60 sec). In addition, the surface modification layer-forming composition 2 was used as a surface modification layer-forming composition. Except for the above, a resist pattern was formed in the same manner as in Example 9.

### (Example 12)

The silicon-containing underlayer film-forming composition 1 was applied on the organic underlayer film by spin coating, heated at 215°C for 1 minute, and then baked at 400°C (1 min under N₂). Except for the above, a resist pattern was formed in the same manner as in Example 9.

For each pattern obtained in Examples 9 to 12, whether or not a line and space pattern having a 28 nm pitch and a 14 nm width could be formed was evaluated by confirming a pattern shape by pattern cross-section observation.

In the observation of the pattern shape, a state in which the pattern had a shape between the footing and the undercut and there was no significant residue in the space portion was evaluated as "favorable", and an unfavorable state in which the lower portions of the resist patterns were in contact with each other was evaluated as "bridge". The obtained results are shown in Table 4.

**[Table 4]**

| | Si-containing underlayer film-forming composition | Pre-treatment | Surface modification layer-forming composition | EUV pattern shape |
|---|---|---|---|---|
| Example 9 | 1 | None | 1 | Favorable |
| Example 10 | 5 | None | 1 | Favorable |
| Example 11 | 1 | 02 etching | 2 | Favorable |
| Example 12 | 1 | 400 degree baking (under nitrogen) | 1 | Favorable |

### [8] Formation of metal oxide resist pattern by EUV exposure: negative solvent development

### (Example 13)

The organic resist underlayer film-forming composition was applied onto a silicon wafer using a spinner, and baked on a hot plate at 215°C for 60 seconds to form an organic underlayer film (A layer) having a film thickness of 60 nm.

The silicon-containing underlayer film-forming composition 1 was applied thereon by spin coating, and heated at 215°C for 1 minute to form a Si-containing underlayer film (B layer) (20 nm). Thereafter, the surface modification layer-forming composition 1 was applied onto the Si-containing underlayer film, and then heated on a hot plate at 180°C for 1 minute, and further rinsed with a solution of propylene glycol monomethyl ether/propylene glycol monomethyl ether acetate = 7/3 (mass ratio) (thinning liquid), and thinned to form a surface modification layer. As described above, a Si-containing underlayer film having a surface modification layer (film thickness: 1 nm) thereon was obtained.

Further, a resist solution for EUV (Sn-containing metal oxide resist) was applied thereon by spin coating, and heated at 100°C for 1 minute to form an EUV resist film (C layer), and then the EUV resist film (C layer) was exposed using an EUV exposure apparatus (NXE3400) manufactured by ASML under the conditions of NA = 0.33, σ = 0.60/0.82, and Quadropole.

After the exposure, post-exposure heating (PEB, 180°C, for 1 minute) was performed, the film was cooled on a cooling plate to room temperature, development was performed for 30 seconds using propylene glycol monomethyl ether acetate, and post-development heating (250°C for 1 minute) was performed to form a resist pattern.

### (Example 14)

A resist pattern was formed in the same manner as in Example 13 except that the silicon-containing underlayer film-forming composition 5 was used.

### (Example 15)

The silicon-containing underlayer film-forming composition 1 was applied on the organic underlayer film by spin coating, heated at 215°C for 1 minute, and then subjected to an O₂ etching treatment (oxygen plasma etching treatment: O₂ 40 sccm, 100 W, 8 Pa, 60 sec). In addition, the surface modification layer-forming composition 2 was used as a surface modification layer-forming composition. Except for the above, a resist pattern was formed in the same manner as in Example 13.

### (Example 16)

The silicon-containing underlayer film-forming composition 1 was applied on the organic underlayer film by spin coating, heated at 215°C for 1 minute, and then baked at 400°C (1 min under N₂). Except for the above, a resist pattern was formed in the same manner as in Example 13.

For each pattern obtained in Examples 13 to 16, whether or not a line and space pattern having a 28 nm pitch and a 14 nm width could be formed was evaluated by confirming a pattern shape by pattern cross-section observation.

In the observation of the pattern shape, a state in which the pattern had a shape between the footing and the undercut and there was no significant residue in the space portion was evaluated as "favorable", and an unfavorable state in which the lower portions of the resist patterns were in contact with each other was evaluated as "bridge". The obtained results are shown in Table 5.

**[Table 5]**

| | Si-containing underlayer film-forming composition | Pre-treatment | Surface modification layer-forming composition | EUV pattern shape |
|---|---|---|---|---|
| Example 13 | 1 | None | 1 | Favorable |
| Example 14 | 5 | None | 1 | Favorable |
| Example 15 | 1 | 02 etching | 2 | Favorable |
| Example 16 | 1 | 400 degree baking (under nitrogen) | 1 | Favorable |

## Claims

1. A composition for forming a silicon-containing underlayer film on which a surface modification layer having a film thickness of 5 nm or less is formed, the composition comprising:
component [A]: a polysiloxane including 30 mol% or more of Q units relative to all units; and
component [B]: water, the composition not comprising:
component [C]: a curing catalyst.

2. A composition for forming a silicon-containing underlayer film on which a surface modification layer having a film thickness of 5 nm or less is formed, wherein
the surface modification layer is formed on the silicon-containing underlayer film subjected to at least one of a dry etching treatment, a baking treatment at 250°C or more, and a UV irradiation treatment, and
the composition includes the component [A]: polysiloxane including 30 mol% or more of Q units relative to all units.

3. The silicon-containing underlayer film-forming composition according to claim 2, wherein
atmospheric gas in the dry etching treatment includes at least one of an oxygen gas, a hydrogen gas, a nitrogen gas, and a rare gas, and
a wavelength in the UV irradiation treatment is 170 nm to 370 nm, and atmosphere is either an atmosphere including oxygen or a nitrogen atmosphere.

4. The silicon-containing underlayer film-forming composition according to claim 1 or 2, wherein
the polysiloxane as the component [A] is a hydrolysis condensate of a hydrolyzable silane (Si-1), and
the hydrolyzable silane (Si-1) includes 30 mol% or more of a hydrolyzable silane represented by the following formula (A):
[Chem. 1]
**SiR4** **(A)**
wherein R represents a group or atom bonded to a silicon atom, and each independently represents an alkoxy group, an aralkyloxy group, an acyloxy group, or a halogen atom.

5. The silicon-containing underlayer film-forming composition according to claim 4, wherein the hydrolyzable silane (Si-1) further includes a hydrolyzable silane represented by the following formula (B):
[Chem. 2]
**R¹¹ₐSi(R¹²)₄₋ₐ** **(B)**
wherein R¹¹ represents a group bonded to a silicon atom, and each independently represents an organic group having a number of carbon atoms of 1 to 45,
R¹² is a group or atom bonded to a silicon atom, and each independently represents an alkoxy group, an aralkyloxy group, an acyloxy group, or a halogen atom, and
a represents an integer of 1 to 3.

6. The silicon-containing underlayer film-forming composition according to claim 1 or 2, wherein the surface modification layer is formed using a surface modification layer-forming composition containing a polysiloxane and a solvent.

7. The silicon-containing underlayer film-forming composition according to claim 6, wherein
the polysiloxane contained in the surface modification layer-forming composition is a hydrolysis condensate of a hydrolyzable silane (Si-2), and
the hydrolyzable silane (Si-2) includes a hydrolyzable silane represented by the following formula (S1):
[Chem. 3]
**R²¹ₐSi(R²²)₄₋ₐ** **(S1)**
wherein R²¹ represents a group bonded to a silicon atom, and each independently represents an organic group having a number of carbon atoms of 1 to 45,
R²² is a group or atom bonded to a silicon atom, and each independently represents an alkoxy group, an aralkyloxy group, an acyloxy group, or a halogen atom, and
a represents an integer of 1 to 3.

8. The silicon-containing underlayer film-forming composition according to claim 1 or 2, wherein the component [A] includes a modified polysiloxane in which at least some of silanol groups are alcohol-modified or acetal-protected.

9. The silicon-containing underlayer film-forming composition according to claim 1 or 2, comprising an alcohol-based solvent.

10. The silicon-containing underlayer film-forming composition according to claim 9, wherein the alcohol-based solvent includes propylene glycol monoalkyl ether.

11. The silicon-containing underlayer film-forming composition according to claim 1 or 2, comprising nitric acid.

12. The silicon-containing underlayer film-forming composition according to claim 1 or 2, wherein the composition is used for EUV lithography.

13. A silicon-containing underlayer film, being a cured product of the silicon-containing underlayer film-forming composition according to claim 1 or 2.

14. A semiconductor processing substrate, comprising: a semiconductor substrate; and the silicon-containing underlayer film according to claim 13.

15. A method for producing a semiconductor element, the method comprising:
a step of forming an organic underlayer film on a substrate;
a step of forming a silicon-containing underlayer film using the silicon-containing underlayer film-forming composition according to claim 1 or 2 on the organic underlayer film;
a step of forming a surface modification layer on the silicon-containing underlayer film; and
a step of forming a resist film on the surface modification layer.

16. The method for producing a semiconductor element according to claim 15, wherein the step of forming the silicon-containing underlayer film includes at least one of dry etching treatment, baking treatment at 250°C or more, and UV irradiation treatment.

17. The method for producing a semiconductor element according to claim 16, wherein
atmospheric gas in the dry etching treatment includes at least one of an oxygen gas, a hydrogen gas, a nitrogen gas, and a rare gas, and
a wavelength in the UV irradiation treatment is 170 nm to 370 nm, and atmosphere is either an atmosphere including oxygen or a nitrogen atmosphere.

18. A method for forming a pattern, comprising:
a step of forming an organic underlayer film on a semiconductor substrate;
a step of applying the silicon-containing underlayer film-forming composition according to claim 1 or 2 on the organic underlayer film and baking the composition to form a silicon-containing underlayer film;
a step of forming a surface modification layer on the silicon-containing underlayer film;
a step of forming a resist film on the surface modification layer;
a step of exposing and developing the resist film to obtain a resist pattern;
a step of etching the surface modification layer and the silicon-containing underlayer film using the resist pattern as a mask; and
a step of etching the organic underlayer film using the patterned surface modification layer and silicon-containing underlayer film as a mask.

19. The method for forming a pattern according to claim 18, wherein the step of forming the silicon-containing underlayer film includes at least one of dry etching treatment, baking treatment at 250°C or more, and UV irradiation treatment.

20. The method for forming a pattern according to claim 19, wherein
atmospheric gas in the dry etching treatment includes at least one of an oxygen gas, a hydrogen gas, a nitrogen gas, and a rare gas, and
a wavelength in the UV irradiation treatment is 170 nm to 370 nm, and atmosphere is either an atmosphere including oxygen or a nitrogen atmosphere.

21. The method for forming a pattern according to claim 18, further comprising:
a step of removing the resist underlayer film by a wet method using a chemical liquid after the step of etching the organic underlayer film.
